Europäisches Patentamt

European Patent Office

Office européen des brevets

(19)

(11)  **EP 0 594 286 B1**

(12)  **EUROPEAN PATENT SPECIFICATION**

(45) Date of publication and mention
of the grant of the patent:
**25.11.1998   Bulletin 1998/48**

(51) Int Cl.$^6$: **H01L 23/532**, H01L 23/485,
H01L 21/3205

(21) Application number: **93306663.1**

(22) Date of filing: **23.08.1993**

(54) **Electronic parts with metal wiring and manufacturing method thereof**

Elektronisches Teil mit metallischen Leiterbahnen und Verfahren zu seiner Herstellung

Pièce d'électronique avec interconnexions métalliques et procédé pour sa fabrication

(84) Designated Contracting States:
**DE FR GB**

(30) Priority: **27.08.1992   JP   228264/92**
**15.03.1993   JP   80108/93**

(43) Date of publication of application:
**27.04.1994   Bulletin 1994/17**

(60) Divisional application: **96105263.6 / 0 725 439**

(73) Proprietor: **KABUSHIKI KAISHA TOSHIBA**
**Kawasaki-shi, Kanagawa-ken 210 (JP)**

(72) Inventors:
• **Toyoda, Hiroshi c/o Intellect. Property Division**
**Minato-ku Tokyo (JP)**
• **Kaneko, Hisashi c/o Intellect. Property Division**
**Minato-ku Tokyo (JP)**
• **Hasunuma, Masahiko**
**c/o Intellect. Property Division**
**Minato-ku Tokyo (JP)**
• **Kawanoue, Takashi**
**c/o Intellect. Property Division**
**Minato-ku Tokyo (JP)**
• **Tomita, Hiroshi c/o Intellect. Property Division**
**Minato-ku Tokyo (JP)**
• **Kajita, Akihiro c/o Intellect. Property Division**
**Minato-ku Tokyo (JP)**
• **Miyauchi, Masami c/o Intellect. Property Division**
**Minato-ku Tokyo (JP)**
• **Kawakubo, Takashi**
**c/o Intellect. Property Division**
**Minato-ku Tokyo (JP)**
• **Ito, Sachiyo c/o Intellect. Property Division**
**Minato-ku Tokyo (JP)**

(74) Representative: **Waldren, Robin Michael et al**
**MARKS & CLERK,**
**57-60 Lincoln's Inn Fields**
**London WC2A 3LS (GB)**

(56) References cited:
**EP-A- 0 524 754            US-A- 4 352 239**
**US-A- 4 742 014            US-A- 4 970 574**

• **29TH ANNUAL PROCEEDINGS RELIABILITY**
**PHYSICS, 6 April 1991, LAS VEGAS, NEVADA**
**pages 91 - 96 J. S. MAY**
• **PROCEEDING OF THE INTERNATIONAL**
**ELECTRON DEVICES MEETING, 8 December**
**1991, WASHINGTON, DC pages 281 - 284 T.**
**KIKKAWA ET AL**
• **JOURNAL OF APPLIED PHYSICS., vol.64, no.6,**
**15 September 1988, NEW YORK US pages 3263**
**- 3268 Y. NAKASAKI ET AL**
• **THIN SOLID FILMS, vol.193, no.1/2, 15 December**
**1990, LAUSANNE CH pages 999 - 1007 P. P. J.**
**VAN ENGELEN ET AL**
• **THIN SOLID FILMS, vol.162, no.1, August 1988,**
**LAUSANNE CH pages 171 - 181 A. E.**
**GERSHINSKII ET AL**
• **MATERIALS LETTERS, vol.10, no.7/8, January**
**1991, AMSTERDAM NL pages 344 - 347 Y. K. LEE**
**ET AL**

**Description**

The present invention relates to electronic parts such as integrated circuit (IC) devices, and particularly to electronic parts with metal wiring having higher reliability e.g., the improved electromigration endurance, and manufacturing method thereof.

Recently integration in memory IC devices represented by D-RAMs has been increasing. With the increase, wiring electrically connecting between elements becomes finer. This fineness requires wiring for a higher current density and operating temperature. At the same time, wiring is required for the further improved electromigration endurance, thereby attaining high reliability. However, the electromigration endurance is inversely proportional to a current density and operating temperature. At present, a thin film made of metal such as Al or Al alloys is frequently used for wiring. The electromigration endurance of such metal wiring has been improved by addition of a transition metal such as Cu or Ti in a trace quantity or the bamboo sheath-like grain structure (bamboo structure) which is caused by crystal grain growth. However, it is difficult to attain the reliability of wiring on the order of 0.1 micrometer only by this improvement in electromigration endurance. Recent investigations revealed that the electromigration endurance and stress-migration endurance due to tensile stress introduced in wiring were remarkably increased by a single-crystal wiring. As a means for attaining high reliability, it is considered that the crystalline properties of a metal thin film are as near to those of single crystal as possible.

At present, in electronic parts such as memory IC devices, metal wiring is formed on the surface of an amorphous thin film generally represented by a $SiO_2$ interlayer insulative film with or without a barrier layer. Thus a metal thin film with the high crystalline properties cannot be formed by a so-called epitaxial crystal growth method where a single-crystal thin film can be grown by continuing the crystalline arrangement of an underlayer. As a result, metal wiring with the excellent electromigration endurance and high reliability is hardly obtained.

As described above, there is a problem that conventional electronic parts hardly have metal wiring with the high reliability.

An object of the invention is to provide electronic parts allowing finer elements, higher integration, higher current density, and higher temperature of operation conditions.

Another object of the invention is to provide electronic parts with highly reliable metal wiring obtained by the formation of a metal thin film with the high crystalline properties.

A further object of the invention is to provide electronic parts with highly reliable metal wiring obtained by an underlying layer of which electrical resistance in a contact part is satisfactorily low and which can be easily processed, and a metal thin film with the high crystalline properties formed on the underlying layer.

A still further object of the invention is to provide electronic parts with highly reliable metal wiring simultaneously preventing wiring failures and shortcircuit.

A still further object of the invention is to provide electronic parts with metal wiring with the improved electromigration and stress-migration endurance.

A big problem for obtaining a metal thin film with the high crystalline properties is that many crystal nucleuses, from which growth of thin films will start, are simultaneously formed on an underlying layer to be deposited thereon at an initial stage of the deposition. At a film-growing stage, crystal growth of these crystal nucleuses is advanced by absorbing deposited particles or uniting with other nucleuses. However, the size of the crystal nucleuses growing by this mechanism is limited. A finally obtained thin film is of polycrystalline where individual crystal grains have different orientation arrangements. Accordingly, in order to form a thin film with the high crystalline properties in a large region, it is important to suppress occurrence of nucleuses as low as possible.

Here, the occurrence of nucleuses is considered based on classic argument. In the case where the surface/interfacial energy relationship between a deposited material and underlying material as shown in the equation (1) is satisfied (a wetting angle is zero), so-called layer growth can be attained and the density of nucleuses occurrence becomes zero.

$$\gamma f \leqq \gamma s - \gamma i \qquad\qquad (1)$$

$\gamma f$ :     the surface energy of a deposited material
$ys$ :     the surface energy of an underlying material
$yi$ :     the interfacial energy

Here, it is said that the interfacial energy $\gamma i$ depends on 1) lattice matching of a deposited material and underlying material, and 2) interatomic bonding energy between a deposited material and underlying material, in crystal-crystal interface. However, in the case where an amorphous material is used as an underlying material like at the time of forming metal wiring in semiconductor devices, it has not been found on what the surface energy of underlying material and interfacial energy depends.

The inventors have eagerly investigated and examined relationships of atomic arrangement at an interface in detail. As a result, it was found that atomic or molecular arrangement at an interface significantly effected crystal arrangement of a deposited material in the case where an amorphous material is used as an underlying layer as well. Namely, diffraction by X-ray, electron beam and the like revealed that even in an amorphous material, the structure thereof is not completely disordered and there exists regular structure in a small range. As described above, the magnitude of interfaceial energy, which determines atomic arrangement at an interface, is determined by the degree of lattice matching of 2 to 3 periods. This small lattice size is substantially the same as an interatomic distance corresponding to a peak of halo pattern which appears in diffraction measurement of an amorphous material. Thus, in this invention, it was found that this interatomic distance was matched with the spacing of atoms or molecules of a deposited material so that interface energy could be reduced, resulting in the formation of a thin film with the very high crystalline properties. Namely, the present invention provides an electronic device comprising: an amorphous thin film formed on a substrate, said amorphous thin film having ordered structure over a short range, and a metal wiring having crystalline structure formed directly on the surface of the amorphous thin film; wherein the interatomic distance of the ordered structure of the amorphous thin film approximately matches the spacing of those crystal planes of the metal wiring which include atoms separated by the first-nearest interatomic distance.

At this time, it is most preferable that the interatomic distance ds of the amorphous thin film matches with the spacing df of the metal wiring. However, a slight dismatch is allowed and the following equation is preferably satisfied;

$$| df - ds | /ds \leqq 0.25$$

Moreover, the above particular crystal plane defined with the first-nearest interatomic distance of the metal wiring is, for example, (111), (200) or (220) in fcc structure; (110) in bcc structure; or (002) or (110) in hexagonal system. The particular crystal plane is not limited to an orientated plane. Composition of the amorphous thin film varies the degree of match. If the amorphous thin film contains an element mainly constituting the metal wiring, a better matching can be obtained.

Another factor controlling interfacial energy is bonding energy as well as a crystal-crystal system. In other words, increase in bonding energy can reduce interfacial energy. Thus, the amorphous thin film preferably contains an element M of which the metal wiring is mainly made. Otherwise, the amorphous thin film preferably contains an element A forming an intermetallic compound with the element M, or an element B capable of continuous series of solid solution with the element M or having the range allowing a complete solid solution. Here, Al, Cu, Au, Ag, or W can be generally used as an element M.

As surface energy γs of an underlying material increases, a deposited material is more easily layer-like grown. However, since the surface energy is measured around the melting point of a material, it is substantially impossible to measure the surface energy of an amorphous material, because a crystallization temperature is lower than a melting point. It was examined what influences the surface energy of an amorphous material. As a result, it was found that it related with the surface energy thereof in a crystal state. That is, in order to increase the surface energy γs of an underlying material, the surface energy of a material in a crystal state constituting the amorphous thin film is preferably larger than the surface energy of a material constituting metal wiring (deposited material). Thus, the melting point, roughly proportional to the surface energy, of a material in a crystal state constituting the amorphous thin film is desirably high. Here, the surface energy of an amorphous material formed of a plurality of elements is defined as the sum of the fractional surface energies of individual elements.

Substrates of the invention are not particularly limited. Conventional semiconductor substrates such as a Si substrate and GaAs substrate, and glass substrates with and without ITO may be used. The shape thereof may be flat or have grooves.

For example, simple metals, alloys or conductive compounds capable of being amorphous are used for an amorphous thin film formed on a substrate. Further, they preferably have composition containing at least one of the above-mentioned elements M, A, and B. Considering the ability of forming amorphous, transition metals, metalloids, semiconductor alloys, and semiconductor compounds are preferable.

Concretely there are compositions containing two or more materials selected from a metal element M, III A group elements (Sc, Y, Lanthanide), IV A group elements (Ti, Zr, Hf), V A group elements (V, Nb, Ta), VI A group elements (Cr, Mo, W), VIII group elements (Fe, Ru, Os, Co, Rh, Ir, Ni, Pd, Pt), B, C, N, O, P, Si, and Ge. Compounds with perovskite type oxide compositions can be used as an amorphous thin film.

Amorphous thin films used in this invention are an amorphous thin film where a broad diffraction intensity, namely halo peak, can be measured in diffraction measurements represented by electron diffraction such as RHEED and X-ray diffraction. Diffraction lines from fine crystals such as intermetallic compounds due to incomplete amorphous state are allowed for amorphous thin films used in this invention. Further amorphous thin films used in this invention are not required to be entirely amorphous. Crystalline thin films of which only the surface is amorphous may be used.

The thickness thereof is preferably thin, more preferably 10 to 1000Å (10Å = 1nm) where the substrate does not expose. However, even if thickness of 1000Å or more, the crystalline properties of metal thin film formed thereon can be improved.

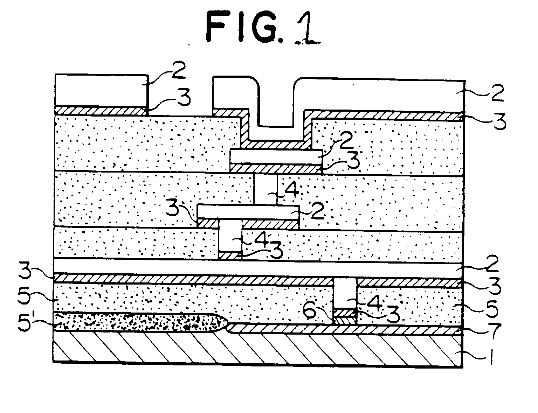

As shown in Fig. 1, this amorphous thin film 3 can be used not only as an underlying layer for a single-layer wiring but also as an underlying layer for each metal wiring 2 constituting multi-layer wirings. In addition, the film 3 can be used as an under-layer for a conductive connecting part in the longitudinal direction such as a via 4 or through hole. Further, the film 3 may be formed directly on the substrate 1; or on an interposed layer, for example, an insulative layer 5 such as a $SiO_2$ thermal oxide film, a barrier layer 6 of Ti, TiN or the like, a contact layer or another wiring above the substrate 1. Here, the interposed layer may be flat or have grooves. In this drawing, reference numeral 5 indicates an insulative film such as $SiO_2$ destined for an element isolation area, and reference numeral 7 indicates a doped layer.

According to the invention, the formation of an amorphous thin film between a substrate and metal wiring can suppress reactions caused by grain boundary diffusion in conventional technique. Among others, an Al amorphous alloy as an amorphous thin film does not form a high resistance reactive layer with metal wiring mainly formed of Al, resulting in a high reliable contact part. Further, if an alloy containing one of Ta, Nb, V, Mo and W is used as an Al amorphous alloy, a simultaneous fine wiring process for metal mainly formed of Al is possible, thereby reducing the number of processes as compared with the other amorphous alloys. At this time, the content of Al is preferably 15 at% or more for stabilizing amorphous state. The content is more preferably 15 to 80 at% to maintain the surface energy of the amorphous thin film to be high. Examples of such Al amorphous alloys are $Td_xAl_{1-x}$ ($0.20 \leqq x \leqq 0.85$), $Nb_xAl_{1-x}$ ($0.20 \leqq x \leqq 0.85$), $V_xAl_{1-x}$ ($0.20 \leqq x \leqq 0.60$), $W_xAl_{1-x}$ ($0.15 \leqq x \leqq 0.50$) and $Mo_xAl_{1-x}$ ($0.25 \leqq x \leqq 0.80$). Further, since Cu amorphous alloys have excellent contact properties with metal wiring mainly made of Cu, a contact part with the high reliability can be provided. Examples of such Cu amorphous alloys are $Ti_xCu_{1-x}$ ($0.18 \leqq x \leqq 0.70$), $Zr_xCu_{1-x}$ ($0.18 \leqq x \leqq 0.70$), $Hf_xCu_{1-x}$ ($0.20 \leqq x \leqq 0.70$), $Y_xCu_{1-x}$ ($0.10 \leqq x \leqq 0.53$) and $Ta_xCu_{1-x}$ ($0.20 \leqq x \leqq 0.80$). Especially for metal wiring mainly made of Cu where required electrical resistance is as low as balk material, amorphous alloys such as $V_xCo_{1-x}$ ($0.15 \leqq x \leqq 0.80$), $Nb_xCr_{1-x}$ ($0.25 \leqq x \leqq 0.45$), $Nb_xCo_{1-x}$ ($0.22 \leqq x \leqq 0.55$), $Ta_xCr_{1-x}$ ($0.25 \leqq x \leqq 0.40$), $Ta_xCo_{1-x}$ ($0.25 \leqq x \leqq 0.45$), $Cr_xCo_{1-x}$ ($0.50 \leqq x \leqq 0.70$), $Mo_xCo_{1-x}$ ($0.20 \leqq x \leqq 0.60$), and $W_xCo_{100-x}$ ($0.20 \leqq x \leqq 0.60$) are also preferably used since they do not form solid solution, and can avoid the inherent electrical resistance increase by interfacial reaction at elevated temperature for sintering. In these amorphous alloys, if a so-called metalloid element such as Si, Ge, P or B is contained, the stability of being amorphous can be further enhanced. Moreover, an amorphous thin film may be of multi-layer structure where different amorphous materials are laminated. At this time, the upper most surface is preferably formed of the above-mentioned amorphous alloys with the high surface energy; and $SiO_2$, polyimide, TEOS, SiN and the like containing B or P may be used as the underlying layer of the above multi-layer structure.

The above-mentioned metal wiring, which is formed on an amorphous thin film, is formed of crystal with the high orientation and crystalline properties which is oriented in a given plane direction. In the case of highly oriented crystal, the angle formed between the normal line direction of the close-packed plane of each crystal grain and the normal line direction of the bottom surface of metal wiring is preferably 80° or less. In the case where metal wiring is of single crystal, the angle between the close-packed plane and the wiring longitudinal direction is preferably 20° or less. At this time, metal wiring is formed such that a (111) plane of the close-packed plane in the case where metal wiring crystal structure is fcc structure; a (110) plane in the case of bcc structure; or a (0001) plane in the case of hexagonal structure is approximately parallel to the wiring longitudinal direction. Moreover, taking into account the degree of freedom in wiring design, the close-packed plane is preferably an upper plane, that is, metal wiring oriented in the close-packed plane is preferably formed.

This metal wiring can be used not only in a single-layer wiring but also in multi-layer wirings and a conductive connecting part in the longitudinal direction thereof, namely, a via or through hole. Even if a material of the conductive connecting part in the longitudinal direction is different from that of a wiring layer above or under the part, continuity of the crystalline orientation of the metal wiring can be maintained, thus allowing the improved reliability. Further, this metal wiring may be of multi-layer structure where different kinds of metals or metals with different crystal states are laminated.

Illustrative materials for such metal wirings have the low electric resistance, and are fcc structured pure Al, pure Cu, pure Au, pure Ag, Al-Cu, Al-Ti, Al-Cr, Al-Ta, Al-Mg, Al-In, Al-Li, Cu-Be, Cu-Ag, Au-Pt, Au-Ag, Au-Pd, Au-Cu, bcc structured pure W. In the case of an alloy, the amount of addition of a solute is desirably in the range allowing a complete solid solution. In this case, Si may be contained in 1wt% or less.

Metals with a high melting point or silicides, nitrides, oxides or carbides of metals with a high melting point may coat on the metal wiring.

Electronic parts thus constructed of the invention are manufactured in the following manner. First, if necessary, an insulative layer, a barrier layer, a contact layer and the like are formed on a substrate. Thereafter, an amorphous thin film is formed by conventional deposition methods such as a sputter method such that an interatomic distance corresponding to a peak featuring in the diffraction pattern of the amorphous thin film is approximately matched to a particular set of crystal planes of the metal wiring to be formed thereon. Subsequently, while keeping vacuum, the metal wiring is formed If the amorphous thin film is exposed to the air, the surface is cleaned by Ar bias sputtering and the like, and then the metal wiring is formed. However, in the case where an amorphous thin film contains B, C, N, O or the like and the high surface energy state of the amorphous thin film is maintained at an oxygen or nitrogen atmosphere, an oxide layer is hardly formed on the surface, even if the amorphous thin film is exposed to the air. Thus, metal wiring may be formed without surface cleaning. In the formation of metal wiring, desirable methods for forming a metal thin film by physical vapor deposition include a sputter method, bias sputter method and ion beam method. Desirable methods for forming a metal thin film by chemical vapor deposition include, for example in the case of an Al-CVD method, a thermal chemical vapor deposition (CVD) method with the use of alkylaluminum such as TIBA or alkylaluminum hydride such as DMAH as a source gas. In these methods, for example, Si or Cu may be contained in the source gas during film deposition. An alloy may be made by lamination by ion implantation or sputtering, and subsequent heat treatment after film deposition.

Further, an amorphous thin film and metal wiring may be formed thereon via an insulative layer and the like to construct multi-layer wirings.

Further, a graphoepitaxy method may be used with processing the surface of the substrate. It is previously described that crystal of a metal thin film formed on an amorphous thin film of an underlying layer with the high surface energy has the extremely high orientation, and is oriented in a given plane direction. It appears that if the surface energy of the under layer is high, a wetting angle of nucleuses vapor-deposited is small and thereby, for example in the case of Al, a (111) plane with low surface energy can stably grow. However, at this time, directions in a plane of the growing nucleuses are at random. Thus, control of directions in a plane is required for the higher wiring reliability. According to an embodiment of the invention, an amorphous thin film with grooves formed thereon is used as an underlying layer, and thereby not only the crystalline properties of a metal thin film to be formed but also control of directions in a plane are sufficiently enhanced. In the amorphous thin film, the bottom part of the grooves may be made of a material different from or identical to that of which the side wall part is made. However, it is preferable that the bottom part and side wall part of the grooves are made of different materials and difference therebetween in the surface energy is utilized at the time of forming a metal thin film. The reasons therefor are as follows; A material to be deposited orientates and grows in a part with higher surface energy than the bottom or side wall part with lower surface energy. At the same time, direction of the other axis of deposited film can be controlled at an interface with the other low-surface-energy part. As a result, a metal thin film similar to single crystal can be formed. Further, in this case, even if an amorphous thin film is subjected to thermal treatment to be crystallized before or after the deposition of a metal thin film, a metal thin film with the high crystalline properties can be obtained.

Desirable grooves are as follows: The shape of the grooves is a stripe, rectangle, square, regular triangle or combination thereof. Many of such grooves are arranged such that one side of the groove is parallel to one of the other groove with accuracy of $\pm 5°$. The width of each groove is the average grain size of metal wiring or less and the space of each groove is also the average grain size of metal wiring or less. In the case of stripe-like grooves, the groove width and space are preferably the average grain size of metal wiring or less.

When forming metal wiring on an amorphous thin film, it is important that a surface oxide is not formed on the amorphous thin film, as described above. A preferable method for removing a surface oxide of the amorphous thin film is plasma etching immediately before the deposition of a metal thin film. After etching, it is important to maintain the vacuum to be $1 \times 10^{-6}$ Torr or less. A CVD method or PVD method may be applied as a method for forming a metal thin film. A substrate temperature is preferably raised to promote migration of deposited particles by means such as resistance heating, electron beam irradiation and laser beam irradiation. Further, an oblique vapor deposition method, where a vapor deposited particle flux is oblique against a substrate, is preferable.

Illustrative methods for depositing a conductor layer are various CVD methods as well as physical vapor deposition methods such as a sputtering method and resistance heating vapor deposition method. Illustrative materials of which the conductor layer is formed are Si, WSi, MoSi, pure Al, an Al alloy, pure Cu, a Cu alloy, W, Au, and Ag. Desirable Al alloys are an Al-Cu alloy, Al-Cr alloy and Al-Mg alloy. Alternatively, these materials may be layer-like laminated.

For example, in the case of an Al-CVD method, film-deposition is preferably performed by a thermal CVD method with the use of alkylaluminum such as TIBA or alkylaluminum hydride such as DMAH as a source gas. At this time, Si or Cu may be contained in the source gas during film deposition. An alloy may be made by lamination by ion implantation or sputtering, and subsequent thermal treatment after film deposition.

According to the present invention, as mentioned above, after an amorphous thin film and metal wiring are successively formed on a substrate to produce an electronic device of the invention, a given thermal treatment may be conducted for the purpose of further crystal grain growth in metal wiring of highly oriented crystal. At this time, the amorphous thin film is allowed to be crystallized or disappear by the thermal treatment. Since its crystalline property is improved by the crystal grain growth of the highly oriented crystal, the reliability of the metal wiring can be further improved.

Further, although the present invention relates to the improvement in the reliability of metal wiring as mentioned above, the technique of the invention can be similarly applied to an electrode part of a capacitor or resistance heater in an electronic part.

For example, in the case of forming an under electrode of a capacitor, if an interatomic distance corresponding to a peak of halo pattern appearing in diffraction measurement of an amorphous thin film of an underlying layer approximately matches with a spacing of a particular crystal plane defined with the first adjacent interatomic distance of the under electrode, the interface energy between the amorphous thin film and under electrode is reduced so that the under electrode with the very excellent crystalline properties can be formed. Accordingly, the crystalline properties of a dielectric thin film formed thereon is enhanced.

If an amorphous thin film is used as a resistance heater uniform and stable electrical resistance can be attained. Further if an electrode is deposited on this amorphous thin film such that the interatomic distance of the amorphous thin film approximately matches with the spacing of the electrode, the crystalline properties of the electrode are improved and electromigration induced degradation is suppressed at the time of a large current application.

Fig. 1 is a sectional view showing a layer-structure of the invention.

Fig. 2 is a view showing a multi-target sputter apparatus for use in the invention.

Fig. 3 is a sectional view according to Example 1.

Fig. 4 is a sectional view according to Example 3.

Fig. 5 is a sectional view according to Example 5.

Fig. 6 is a sectional view according to Example 6.

Fig. 7 is a sectional view according to Example 7.

Fig. 8 is a sectional view according to Example 8.

Figs. 9 (a) to (f) are sectional view showing a method for forming a wiring according to Example 9.

Fig. 10 is a view showing results of an accelerated test according to Example 9.

Fig. 11 is a sectional view according to Example 10.

Fig. 12 is a plan view showing a test substrate with a wiring part according to Example 11.

Fig. 13 is a sectional view according to Example 14.

Fig. 14 is a sectional view according to Example 16.

Fig. 15 is a sectional view according to Example 17.

Fig. 16 is a sectional view according to Example 18.

Fig. 17 is a sectional view according to Example 19.

Figs.18 (a) to (g) are sectional views according to Example 21.

Fig. 19 is a sectional view according to Example 21.

Figs.20 (a) to (e) are sectional views showing a flow of steps according to Example 23.

Fig. 21 is a sectional view according to Example 25.

Fig. 22 is a sectional view according to Example 28 and Example 29.

Fig. 23 is a view showing a four-terminal pattern according to Example 35.

Embodiments of the present invention will be described in more detail.

Example 1

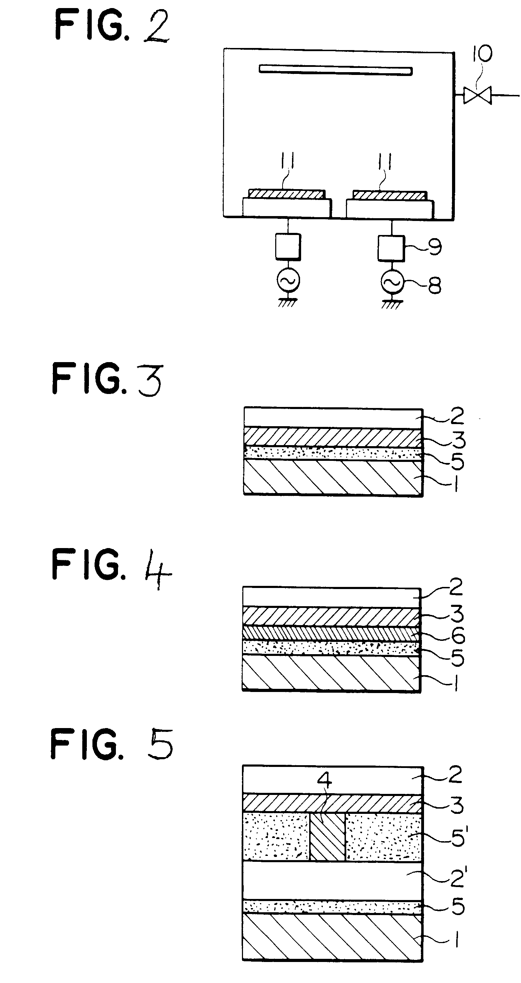

Referring to Figs. 2 and 3, an embodiment will be described.

Using a six-inch silicon wafer substrate 1 with a 4000Å insulative layer 5 of a thermal oxide film ($SiO_2$), an amorphous thin film 3 and metal wiring 2 were successively formed by sputtering. First, an AlTa film was formed as an amorphous thin film 3 by means of a multi-target sputter apparatus as shown in Fig. 2. The sputtering conditions are shown below. In Fig. 2, reference numeral 8 indicates a high frequency power source, 9 a matching circuit, 10 a mass flow controller, 11 a target.

Sputter system: RF magnetron system
Target: 100 mm$\phi$ AlTa mosaic target (concentric circle like form)
Substrate temperature: Room temperature (25°C)
Sputter gas: Ar
Gas pressure: 0.20Pa
Applied power: 10W/cm$^2$
Film thickness: 500Å

Composition analysis revealed that the formed film was $Al_{40}Ta_{60}$ (hereinafter, numeral value shows ratio of an atomic composition). X-ray diffraction revealed that the film was amorphous and that an interatomic distance ds corresponding to peak of halo pattern was 2.34Å. The following fact was found. Namely, since a spacing df of Al (111) was 2.34Å, the relation, ldf-dsl/ds=0 was satisfied. Thus, if the amorphous thin film contains an element mainly forming metal wiring and has an appreciate composition, the spacing ds can match with the spacing of a particular crystal plane of the metal wiring. In this embodiment, a mosaic target was used. However, other methods such as simultaneous sputtering with the use of a binary target and lamination of each element could produce a similar amorphous thin film.

Next, keeping vacuum, Al was sputtered on the $Al_{40}Ta_{60}$ film. The sputtering conditions are shown below.

Sputter system: RF magnetron system
Target: 100 mm$\phi$ Al target
Substrate temperature: Room temperature (25°C)
Sputter gas: Ar
Gas pressure: 1Pa
Applied power: 5W/cm$^2$
Film thickness: 4000Å

The Al film thus formed was evaluated for the orientation and crystalline properties by X-ray diffraction. The full width of half-maximum (hereinafter referred to as FWHM) of a (111) rocking curve (orientation FWHM) was 1.2° and bragg reflection other than (hhh) reflection, for example (200), (220) or the like, was not observed.

The film thus formed with a layer-structure shown in Fig. 3 was processed into a four-terminal pattern 0.5μm in width and 1mm in length, and subjected to an electromigration (EM) test. The test conditions were that a wiring temperature was 200°C and a current density was $2 \times 10^6 A/cm^2$. As a result of the test, it was confirmed that even after an elapsed time of 1000 hours there was no failure and excellent reliability was obtained. When the electric resistance increased by 10% of a value just after the test starts in the EM test, it was judged that wiring failure took place. This judgement was the same in the following examples.

Similarly, various combinations of an amorphous thin film and metal wiring (an amorphous thin film/metal wiring); that is, $(Pt_{21}Zr_{79}/Pt)$, $(Cu_{50}Ti_{50}/Cu)$, $(Ag_{55}Cu_{45}/Ag)$, and $(Fe_{80}B_{20}/Fe)$; were formed. Similar evaluation of the orientation FWHM revealed that Pt, Cu and Ag were (111) orientation and the FWHMs thereof were 1.4°, 1.8° and 1.6° respectively; and Fe was (110) orientation and the orientation FWHM of (110) reflection thereof was 1.7°.

Example 2

Like Example 1, an amorphous thin film made of $Ni_{30}Ta_{70}$ (melting point of intermetallic compound of $Ni_{30}Ta_{70}$ : 1500°C) was formed and a metal wiring made of Al (melting point: 660°C) was formed thereon. Namely, the amorphous thin film contained an element which has a melting point higher than that of a metal wiring and which could constitute an intermetallic compound with a main element forming the metal wiring. Here, an interatomic distance ds of $Ni_{30}Ta_{70}$ corresponding to a peak of halo pattern was 2.33Å. This approximately matches with a spacing df 2.34Å of Al (111). As a result of evaluation similar to Example 1, (111) orientation FWHM of 0.9° and excellent crystalline properties were observed. Further, in the EM test, it was confirmed that even after an elapsed time of 1000 hours there was no failure and excellent reliability was also obtained.

Similarly, various combinations of an amorphous thin film and metal wiring (an amorphous thin film/metal wiring); that is, $(Pd_{80}Si_{20}/Al)$, $(Ag_{55}Cu_{45}/Al)$, and $(W_{70}Zr_{30}/Al)$; were formed. Similar evaluation revealed that the (111) orientation FWHMs thereof were 1.9°, 1.8° and 1.2 respectively.

Example 3

Like Example 1, an amorphous thin film made of a Co-based alloy, $Co_{80}Zr_9Nb_{11}$ was formed and a metal wiring made of Al was formed thereon. Here, an interatomic distance ds of $Co_{80}Zr_9Nb_{11}$ corresponding to a peak of halo pattern was 2.04Å. This approximately matches with a spacing df 2.02Å of Al (200). As a result of evaluation similar to Example 1, (111) orientation and excellent crystalline properties were observed. Further, in the EM test, it was confirmed that even after an elapsed time of 1000 hours there was no failure and excellent reliability was obtained.

Similarly, various combinations of an amorphous thin film and metal wiring (an amorphous thin film/metal wiring); that is, $(Co_{80}Zr_8Nb_{12}/Al)$, $(Co_{85}Zr_6Nb_9/Al)$, $(Co_{88}Zr_8Ta_9/Al)$, and $(Co_{90}Hf_6Pd_4/Al)$; were formed. Similar evaluation revealed that the (111) orientation FWHMs thereof were 1.2° and satisfactory crystalline properties was obtained.

As shown in Fig. 4, Al metal wirings 2 were formed after various combinations of the following steps; these steps were that a polycrystalline TiN/Ti layer was formed on the insulative layer 5 as a barrier layer 6, that an amorphous thin film 3 ($Co_{80}Zr_9Nb_{11}$) was formed thereon, that thereafter it was exposed to the air as shown in Table 1, and that it was then subjected to Ar bias sputtering. The crystalline orientation of these Al metal wirings were evaluated with the FWHM of an Al(111) rocking curve by X-ray diffraction using a CuKα line. As shown in Table 1, in the cases of no amorphous thin film and no Ar bias sputtering after exposure to the air, the crystalline orientation was remarkably degraded.

Table 1

| | Underlying material | | | Surface treatment | | FWHM of a (111) rocking curve of metal wiring |
|---|---|---|---|---|---|---|
| | SiO2 layer | TiN/Ti layer | Amorphous thin film | Exposure to air | Ar bias sputtering | |
| 1 | O | - | O | - | - | 1.2° |
| 2 | O | O | O | - | - | 1.2° |
| 3 | O | - | - | - | - | 8° or more |
| 4 | O | O | - | - | - | 4° |
| 5 | O | - | O | O | O | 1.3° |
| 6 | O | O | O | O | O | 1.3° |
| 7 | O | - | O | O | - | 8° |
| 8 | O | O | O | O | - | 8° |
| 9 | - | O | O | - | - | 1.2° |

O: Yes (existent or conducted),    -: No (non-existent or non-conducted)

EP 0 594 286 B1

Example 4

Like Example 1, amorphous thin films and metal wirings shown in Table 2 were formed. As also shown in Table 2, in this embodiment, amorphous thin films with larger surface energy than that of metal wiring in the crystalline state were used.

Table 2

| | Amorphous thin film | | | Metal wiring | | | $|df-ds|/ds$ | FWHM of a (111) rocking curve of metal wiring |
|---|---|---|---|---|---|---|---|---|
| | Composition | Interatomic distance ds (Å) | Surface energy (erg/cm2) | Composition | Spacing df (Å) | Surface energy (erg/cm2) | | |
| 1 | Ni62Nb38 | 2.11 | 1826 | Al | (200)2.02 | 866 | 0.04 | 1.1° |
| 2 | Ni30Zr70 | 2.51 | 1570 | Al | (111)2.34 | 866 | 0.07 | 1.2° |
| 3 | TiB2 | 2.01 | 1698 | Al | (200)2.02 | 866 | 0.005 | 1.8° |
| * | SiO2 | 4.78 | 605 | Al | (111)2.34 | 866 | 0.51 | 8.2° |

*: Comparative Example

EP 0 594 286 B1

In each case, a spacing ds corresponding to a peak of halo pattern in the amorphous thin film approximately matches with a lattice distance df of Al. As a result of evaluation similar to Example 1, (111) orientation and excellent crystalline properties were obtained, as shown in Table 2. Further, in the EM test, it was confirmed that even after an elapsed time of 1000 hours there was no failure and excellent reliability was obtained.

For example, borides, carbides and nitrides of $TiB_2$ and the like were preferably used as an amorphous thin film, since their surface energy was large. The surface energy is represented by the following approximation equation;

$$\Delta E^{SV} = Y\lambda^2 / 4\pi^2 X_0$$

$\Delta E^{SV}$ : surface energy
$Y$ : Young's module
$\lambda$ : distance between atoms where force reaches ($X_0$ is an approximate value)
$X_0$ : distance between atoms

At the same time, as a comparative example, a metal wiring was directly formed on $SiO_2$ in a similar way to Example 1. An interatomic distance ds of $SiO_2$ corresponding to a peak of halo pattern does not approximately match even for the nearest spacing df of (111) Al. Further, the surface energy of $SiO_2$ is smaller than that of Al. As a result of evaluation similar to Example 1, the (111) orientation FWHM was as large as 8.2° and in the EM test a wiring failure was observed within 10 hours.

Example 5

Referring to Fig. 5, an embodiment will be described.

In this example, as shown in Fig. 5, a conductive connecting part 4, namely a via, was formed in the longitudinal direction. Concretely, first, a $SiO_2$ thermal oxide film was formed as an insulative layer 5 on a Si substrate 1 and thereafter a 4000Å thick thin film, which was made of Al, Cu, W or $MoSi_2$, was deposited as a under-layer metal wiring 2'. On this thin film, a 3000Å thick $SiO_2$ interlayer insulative film 5' was deposited by means of a thermal CVD method. In this interlayer insulative film 5', a via (or through hole) 4 with a diameter of 50μm was formed by means of conventional PEP, reactive ion etching (RIE) steps.

Next, the via 4 was filled with W by a selective CVD method. After leveling by etchback, a 200Å thick $Co_{80}Zr_9Nb_{11}$ thin film was formed as an amorphous thin film 3 of the present invention. Subsequently, if the surface of $Co_{80}Zr_9Nb_{11}$ was exposed to the air one time, it was subjected to Ar RF plasma cleaning. Then pure Al thin film was deposited as a metal wiring 2 in a thickness of 4000Å by sputtering. The crystalline orientation of the Al thin film was evaluated with the FWHM of an Al (111) rocking curve by X-ray diffraction using a CuKα line. An incident X-ray was diaphragmed to φ50μm by a collimator to examine change and distribution of FWHM near the via. As a result, FWHM did not change dependent on positions and was uniformly 1.3°, thereby exhibiting the excellent crystalline properties.

Example 6

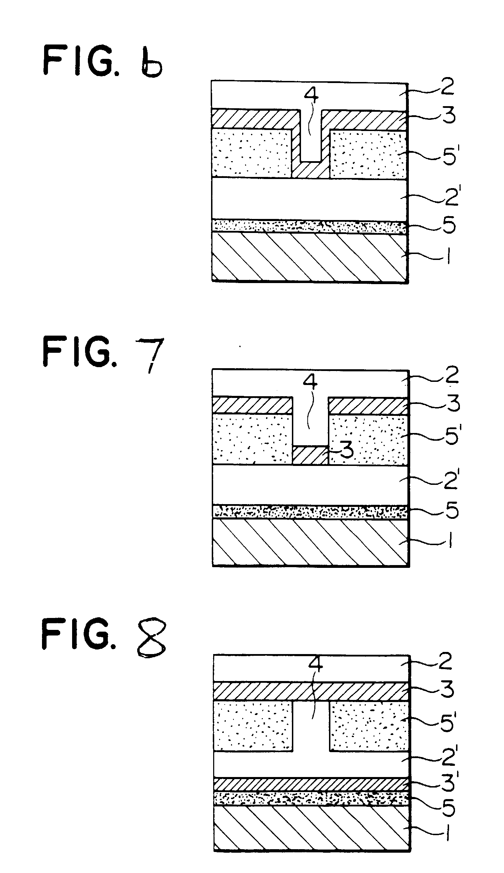

Referring to Fig. 6, an embodiment will be described.

Like Example 5, a via 4 was formed and then, as shown in Fig. 6, $Ni_{62}Nb_{38}$ was formed in a thickness of 300Å as an amorphous thin film 3 by sputtering. As a result, as shown in Fig. 6, although a side wall of the via become slightly thin, a Ni-Nb layer was conformably formed. Under vacuum of 1 x $10^{-7}$ Torr (1 Torr = 133 Pa), a 4000Å thick pure Al thin film was continuously formed as a metal wiring 2 thereon by sputtering. As a result of evaluation similar to Example 5, FWHM was uniformly 1.35°.

Example 7

Referring to Fig. 7, an embodiment will be described.

Like Example 5, a via 4 was formed and then, as shown in Fig. 7 , $Al_{40}Ta_{60}$ was formed as an amorphous thin film 3 by sputtering. At this time, provision of a collimator between a substrate with the via and target improved the direct-advance property of particles to be deposited. Accordingly, an amorphous layer was hardly formed on a side wall of the via 4 and a 100Å Al-Ta amorphous thin film 3 could be formed on the bottom surface of the via 4 and interlayer insulative film 5'. After exposure to the air one time, it was subjected to Ar RF bias sputter cleaning. Then pure Al thin film was deposited in a thickness of 4000Å as a metal wiring 2 by sputtering. As a result of evaluation similar to Example 5, FWHM was uniformly 1.1°.

Example 8

Referring to Fig. 8, an embodiment will be described.

As shown in Fig. 8, first, an $Al_{40}Nb_{60}$ film was formed as an amorphous thin film 3' on an insulative layer 5 formed of a $SiO_2$ thermal oxide film, and thereafter under vacuum of $1 \times 10^{-7}$ Torr or less pure Al was continuously deposited to form an under-layer metal wiring 2' with a thickness of 4000Å. The FWHM of a rocking curve of the under-layer metal wiring 2' was 1.2°. Like Example 5, a $SiO_2$ interlayer insulative film 5' and via 4 were formed on the Al under-layer metal wiring 2'. Next, the via 4 was selectively filled with Al by means of a thermal CVD method using TIBA (triisobuthyl aluminum, $i\text{-}(C_4H_9)_3Al$) as a source gas. This Al with which the via 4 was filled had the continuous crystalline orientation of the lower Al and had the same FWHM of a rocking curve as that of the under-layer metal wiring 2'. Subsequently Al-Nb was continuously deposited in a thickness of 250Å as an amorphous thin film 3 by sputtering. After this had been exposed to the air and then subjected to bias cleaning by Ar RF plasma, an Al film was deposited in a thickness of 250Å as a metal wiring 2 by means of a sputter or thermal CVD method using TIBA. The distribution of the crystalline orientation of this Al film was uniform and the rocking FWHM was 1.2 °. Further, Al may be deposited after removing an amorphous thin film 3 corresponding to the via 4 by a conventional PEP step and ion-milling step. Even the Al film thus obtained had the uniform orientation including the via part, and the FWHM was similarly 1.2 °.

On the other hand, in a comparative example, an amorphous thin film did not exist. According to this comparative example, in the both cases, the FWHM of Al on amorphous $SiO_2$ was about 8° and the uniformity in orientation thereof was not satisfactory, especially the orientation of the via part being considerably disturbed.

Example 9

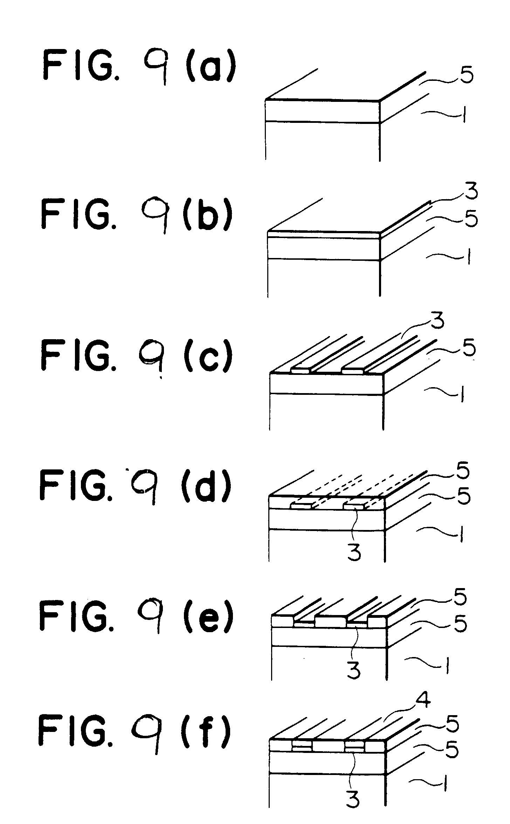

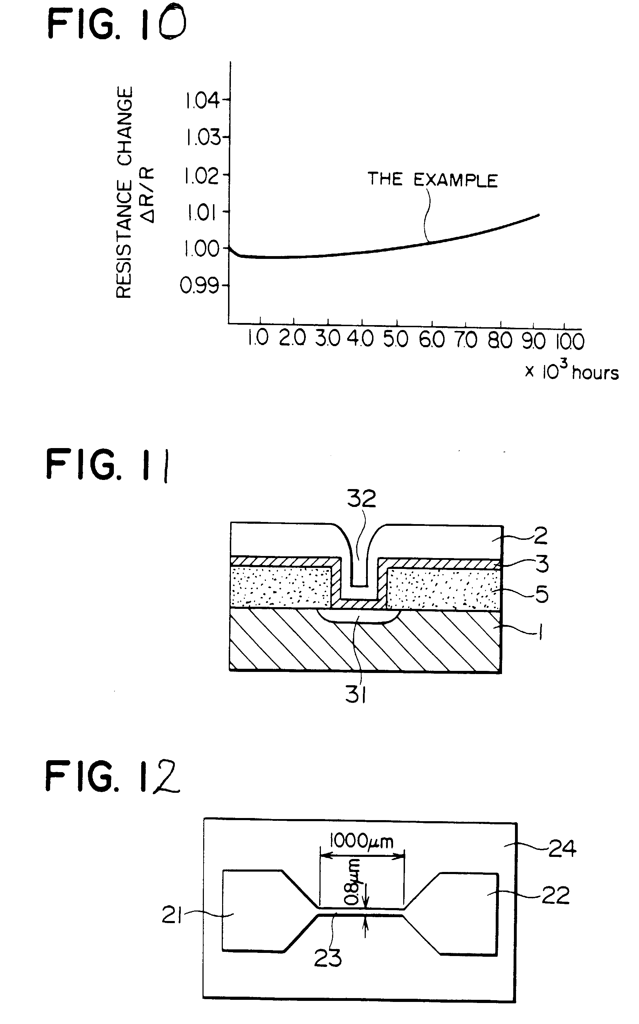

Referring to Figs. 9 and 10, an embodiment will be described.

As shown in Fig. 9 (a), an insulative layer formed of amorphous $SiO_2$ was formed on the surface of a Si substrate 1. First, a 1000Å thick amorphous thin film 3 was deposited on the amorphous $SiO_2$ by a sputter method (Fig. 9 (b)) and then the amorphous thin film 3 on parts other than parts on which wiring would be formed were removed by etching (Fig. 9 (c)). A 5000Å thick insulative layer 5 formed of amorphous $SiO_2$ was uniformly deposited thereon (Fig. 9 (d)). Next, only $SiO_2$ on the amorphous thin film 3 was removed by etching to form a groove in which wiring would be arranged (Fig. 9 (e)). As a result, the bottom surfaces of the grooves were made of the amorphous thin film 3. In this embodiment, the width of the grooves, the width of the metal wiring, was 0.8μm and the depth of the grooves was 4000Å. An ion beam with low energy was irradiated on the above substrate 1 with the grooves to remove an oxide film on the surface of the amorphous thin film 3. Thereafter, Al was deposited by means of a thermal CVD method using TIBA to obtain a metal wiring 4 (Fig. 9 (f)). Selective growth that Al was deposited only in the grooves could be performed at a substrate temperature of 300°C or lower. Table 3 shows the Al deposition speed in the grooves against substrate temperatures in the case where an Al amorphous alloy, as the amorphous thin film 3, was formed on the groove bottom surface. The Al amorphous alloys include $Al_{30}Ta_{70}$, $Al_{40}Nb_{60}$, and $Al_{50}V_{50}$. Further, in order to confirm the selective growth, Table 3 also shows if selective growth for $SiO_2$ was performed in parts other than the grooves. As comparative examples, a film of amorphous $SiO_2$, polycrystalline silicon or polycrystalline silver was formed on the groove bottom surface. The Al deposition speeds and selective growth of the comparative examples are shown in Table 3. As compared with the Al amorphous alloys, if Al was deposited on the amorphous $SiO_2$ and polycrystalline silicon, sufficient Al deposition speed could not be obtained at 300°C or lower and the surface morphology of the filled Al was not satisfactory (rugged surface). Moreover, as compared with the amorphous Al alloys, if Al was deposited on polycrystalline silver, the deposition speed was slower and there were parts where Al was not continuously filled in the line direction of wiring.

Next, the crystalline properties of selectively filled Al were evaluated by X-ray diffraction. The results are shown in Table 4. The Al orientation was evaluated by measuring the FWHM of a rocking curve of an Al(111) diffraction peak. Al filled in the grooves whose under-layer was formed of the Al amorphous alloy has (111) high orientation with the FWHM of about 1°.

Al filled in the grooves whose bottom was formed of the Al amorphous alloy was examined by a transmission electron microscope. The examination revealed that a diameter of Al crystal grains was about 1μm to be substantially the same as the wiring width and that these (111) crystal grains were connected with small angle grain boundaries in the line direction of the wiring. Further, there existed a region which consisted of one crystal grain with length of 10 μm or more in the wiring line direction. This exhibits that a single-crystal Al wiring was partially obtained which had more excellent stress-migration and electromigration endurance than those of (111) high orientation.

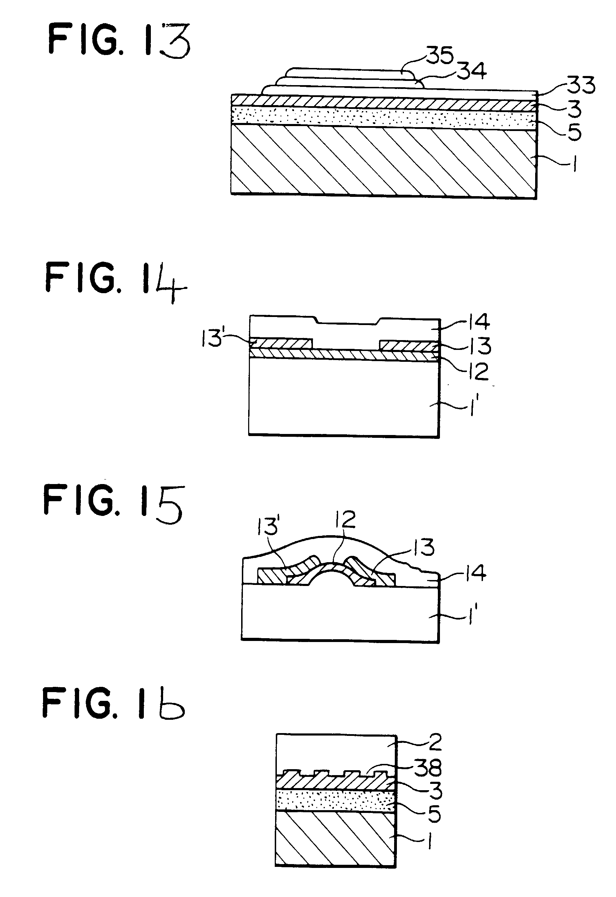

Last, an accelerated test was conducted for studying the electromigration endurance of the Al-filled wiring obtained in the embodiment. The results are shown in Fig. 13. The test conditions are a substrate temperature of 150°C and a current density of $1 \times 10^7$ A/cm². Based on the change in the rate of resistance change as time elapsed, the much higher reliability than a conventional Al wiring was confirmed.

Table 3

| | Constituent material of groove bottom surface | Al deposition speed (A/min) | | | | Selectivity for SiO2 | Continuity of surface form |
|---|---|---|---|---|---|---|---|
| | | 320 (°C) | 300 (°C) | 280 (°C) | 260 (°C) | | |
| Example 9-1 | Al30Ta70 | 1400 | 430 | 170 | 60 | ◎ | ◎ |
| Example 9-2 | Al40Nb60 | 1400 | 430 | 170 | 60 | ◎ | ◎ |
| Example 9-3 | Al50V50 | 1400 | 430 | 170 | 60 | ◎ | ◎ |
| Comparative Example 9-1 | Amorphous SiO2 | 110 | 30 | 10 | 0 | x | x |
| Comparative Example 9-2 | Polycrystalline Si | 150 | 50 | 20 | 0 | Δ | x |
| Comparative Example 9-3 | Polycrystalline Ag | 430 | 150 | 60 | 20 | O | Δ |

Table 4

| | Constituent material of groove bottom surface | Al(111) FWHM (°) |
|---|---|---|
| Example 9-4 | Al30Ta70 | 1.0 |
| Example 9-5 | Al40Nb60 | 1.1 |
| Example 9-6 | Al50V50 | 1.0 |

EP 0 594 286 B1

Example 10

Referring to Fig. 11, an embodiment will be described.

As shown in Fig. 11, a $SiO_2$ insulative layer 5 was formed on a semiconductor substrate 1 with a functional element 31 by means of a CVD method. A region destined for a contact part was removed by etching to from a contacting hole 32. In order to obtain the excellent contact properties, a natural oxide film which was formed on the semiconductor substrate 1 of the contacting hole bottom surface was removed by hydrofluoric acid cleaning. In order to prevent re-oxidization, it was rinsed with pure water with a low oxygen concentration and then dried by highly pure nitrogen gas purge. An Al-Ta amorphous thin film 3 was formed on the substrate by a multi-sputter apparatus. The sputtering conditions are shown below.

Sputter system: RF magnetron system
Target: 100 mm$\phi$ Al-Ta mosaic target
Substrate temperature: Room temperature (25°C)
Sputter gas: Ar
Gas pressure: 0.20Pa
Applied power: 10W/cm$^2$
Film thickness: 400Å

Composition analysis revealed that the formed film was $Al_{55}Ta_{45}$. X-ray diffraction revealed that the film was amorphous. Although the Al amorphous thin film 3 was formed by a sputter method in this embodiment, a similar amorphous film can be formed by a CVD method or vapor deposition method. Further although a Al-Ta mosaic target was used in the sputtering of the Al amorphous thin film 3, a similar amorphous thin film can be obtained by the other methods such as simultaneous sputtering with an Al/Ta binary target or alternate laminating Al and Ta in thin thicknesses.

Keeping vacuum, an Al film was formed thereon by a sputter method. The sputtering conditions are shown below.

Sputter system: RF magnetron system
Target: 100 mm$\phi$ Al target
Substrate temperature: Room temperature (25°C)
Sputter gas: Ar
Gas pressure: 1Pa
Applied power: 5W/cm$^2$
Film thickness: 4000Å

The Al film thus formed was evaluated for the orientation and crystalline properties by X-ray diffraction. The FWHM of a (111) rocking curve was 1.0° and excellent orientation was observed. Namely satisfactory orientation was obtained. Although the Al film was formed by a sputter method in this embodiment, similarly satisfactory layers can be obtained by means of a CVD method and vapor deposition method.

Thereafter a resist was formed in a given pattern by standard lithography technique and dry etching of the Al film and Al-Ta amorphous thin film 3 was simultaneously conducted using an etching gas containing chlorine to process the Al film into a metal wiring 2. After the processing, residue was not observed by SEM (scanning electron microscope) examination and the processability was excellent. This sample was subjected to thermal treatment for 15 minutes at 450°C in a forming gas ($N_2 : H_2 = 9 : 1$) and then a leak current and contact resistance in a conjunction part were measured. They were not changed by the thermal treatment and the excellent barrier property was confirmed.

Example 11

Referring to Fig. 12, an embodiment will be described.

For examining the electromigration endurance of an Al wiring, an Al-Ta amorphous thin film and Al film were formed on a silicon substrate with a thermal oxide film under condition similar to Example 10. As shown in Fig. 12, by using this substrate, a test substrate 24 was made which had an anode 21, a cathode 22 and a 0.8 $\mu$m wide wiring part 23 connecting these electrodes. The orientation and crystalline properties of an Al film of this test substrate was evaluated by X-ray diffraction. As a result, similarly to Example 10, the FWHM of a (111) rocking curve was 1.0°.

A current at a current density of $2 \times 10^6$ A/cm$^2$ was flown in the test substrate 24 at a test temperature of 200°C to measure its average failure time. The value was 1000 hours or more, thereby exhibiting that the test substrate had the high electromigration endurance.

Example 12

In a manner similar to Example 10, Al-Mo amorphous thin film was formed on a substrate with functional elements thereon. As a result of composition analysis, it was found that the formed film was $Al_{60}Mo_{40}$. X-ray diffraction revealed that the film was amorphous. An Al film formed thereon was evaluated for the orientation and crystalline properties by X-ray diffraction. As a result, the FWHM of a (111) rocking curve was 1.1°. Satisfactory orientation was observed.

Thereafter a resist was formed in a given pattern by standard lithography technique, and dry etching of the Al film and Al-Mo amorphous thin film was simultaneously conducted using an etching gas containing chlorine to process the Al film into a metal wiring. After the processing, residue was not observed by SEM examination and the processability was excellent. This sample was subjected to thermal treatment for 15 minutes at 450°C in a forming gas ($N_2 : H_2 = 9 : 1$) and then a section of a conjunction part were measured. No alloy spike was not observed and the excellent barrier property was confirmed.

Example 13

In a manner similar to Example 10, Al-Nb-Si amorphous thin film was formed on a substrate with functional elements thereon. As a result of composition analysis, it was found the formed film was $Al_{40}Nb_{55}Si_5$. X-ray diffraction revealed that the film was amorphous. An Al film formed thereon was evaluated for the orientation and crystalline properties by X-ray diffraction. As a result, the FWHM of a (111) rocking curve was 1.3°. Excellent orientation was observed.

Thereafter a resist was formed in a given pattern by standard lithography technique, and dry etching of the Al film and Al-Nb-Si amorphous thin film was simultaneously conducted using an etching gas containing chlorine to process the Al film into a metal wiring. After the processing, residue was not observed by SEM examination and the processability was excellent. This sample was subjected to thermal treatment for 15 minutes at 450°C in a forming gas ($N_2 : H_2 = 9 : 1$) and then a section of a conjunction part was measured. No alloy spike was observed and the excellent barrier property was confirmed. Moreover, since Si was contained, the thermal stability of the amorphous thin film was improved. Even when the amorphous thin film was subjected to further higher thermal treatment, any crystallization and reaction were not observed. In the cases of Ge, P and B, this advantageous effects were also obtained.

Example 14

Referring to Fig. 13, an embodiment will be described.

A six-inch silicon wafer with a 4000Å insulative film 5 formed of a thermal oxide film was used as a substrate 1. A PtZr amorphous thin film 3 was formed by means of a multi-target sputter apparatus as shown in Fig. 5. The sputtering conditions are shown below.

Sputter system: RF magnetron system
Target: 100 mmφ PtZr mosaic target
Substrate temperature: Room temperature (25°C)
Sputter gas: Ar
Gas pressure: 0.20Pa
Applied power: $10W/cm^2$
Film thickness: 500Å

Composition analysis revealed that the formed film was $Pt_{21}Zr_{79}$. X-ray diffraction revealed that the film was amorphous.

Next, keeping vacuum, Pt was sputtered on the amorphous PtZr film. The sputter conditions are shown below.

Sputter system: RF magnetron system
Target: 100 mmφ Pt target
Substrate temperature: Room temperature (25°C)
Sputter gas: Ar
Gas pressure: 1Pa
Applied power: $5W/cm^2$
Film thickness: 1000Å

The Pt film 33 thus formed as an under electrode was evaluated for the orientation and crystalline properties by X-ray diffraction. The (111) orientation FWHM was 1.4° and satisfactory crystalline properties were observed.

Next, on this under electrode layer, a strontium titanate film 34 was formed as a dielectric thin film by means of a RF magnetron sputter method. A sintered body of strontium titanate was used as a target. The sputter conditions are shown below.

```
Sputter system: RF magnetron system
Target: 100 mmφ SrTiO₃ target
Substrate temperature: 500°C
Sputter gas: Ar/O₂
Gas pressure: IPa
Applied power: 5W/cm²
Film thickness: 5000Å
```

The orientation and crystalline properties of the dielectric thin film were evaluated by X-ray diffraction. The (111) orientation of Pt film 33 was continued and the (111) orientation FWHM was 1.5°. An Au film 35 was vapor deposited on this dielectric thin film as an upper electrode and the capacitor property thereof was evaluated. It was found that dielectric constant and leak current were satisfactory values. On the other hand, the orientation FWHM of a Pt film directly formed on the thermal oxide film was 9.2°. When a strontium titanate film was formed thereon under the above conditions, the orientation FWHM was 9.5°.

Example 15

Like Example 14, using a six-inch silicon wafer substrate with a 4000Å thermal oxide film, a $Pt_{21}Zr_{79}$ film was formed as an amorphous thin film by means of a multi-target sputter apparatus.

Next, keeping vacuum, a PtTi film was formed by sputtering as an under electrode on the amorphous $Pt_{21}Zr_{79}$ film. The sputter conditions are shown below.

```
Sputter system: RF magnetron system
Target: 100 mmφ Pt/Ti binary alloy target
Substrate temperature: Room temperature (25°C)
Sputter gas: Ar
Gas pressure: 1Pa
Applied power: 5W/cm²
Film thickness: 1000Å
```

The PtTi film thus formed was subjected to composition analysis. The analysis revealed that the composition thereof was $Pt_{88}Ti_{12}$. The orientation and crystalline properties thereof were evaluated by X-ray diffraction. The (111) orientation FWHM was 1.4° and satisfactory crystalline properties were observed.

Next, on this under electrode, a ferrodielectric thin film of lead titanate zirconate was grown by means of a RF magnetron sputter method. A used target was a sintered body where powder of lead titanate zirconate added with lead oxide 10 mol% rich was sintered at 1200°C. The sputtering conditions are shown below.

```
Sputter system: RF magnetron system
Target: 100 mmφ Pb(ZrTi)O₃ target (PbO 10 mol% RICH)
Substrate temperature: 600°C
Sputter gas: Ar/O₂
Gas pressure: IPa
Applied power: 5W/cm²
Film thickness: 5000Å
```

The orientation and crystalline properties of the obtained strong dielectric thin film were evaluated by X-ray diffraction. The (111) orientation of the PtTi film was continued and the (111) orientation FWHM was 1.9°. On the other hand, the orientation FWHM of a Pt film directly formed on the thermal oxide film was 9.2°. When a lead titanate zirconate film was formed thereon under the above conditions, the orientation FWHM was 9.8°.

Example 16

Referring to Fig. 14, an embodiment will be described.

On a glass substrate 1', an AlTa amorphous thin film was formed as a resistance heater film 12 by means of a multi-target sputter apparatus as shown in Fig. 2. The sputter conditions are shown below.

Sputter system: RF magnetron system
Target: 100 mmφ Al/Ta binary target
Substrate temperature: Room temperature (25°C)
Sputter gas: Ar
Gas pressure: 0.20Pa
Applied power: 10W/cm$^2$

As a result of composition analysis, it was found that the formed film was $Al_{25}Ta_{75}$. X-ray diffraction revealed that this film was amorphous. In the same chamber, an Al thin film was sputtered thereon. The sputter conditions are shown below.

Sputter system: RF magnetron system
Target: 100 mmφ Al target
Substrate temperature: room temperature (25°C)
Sputter gas: Ar
Gas pressure: IPa
Applied power: 5W/cm$^2$

The crystalline properties of the formed film were evaluated by X-ray diffraction. This film was an oriented film with the FWHM 1.0° of a (111) rocking curve.

Next this Al film was processed by lithography and etching steps to form electrodes 13, 13'. Further a $SiO_2$ insulative film 14 was coated thereon to prevent oxidation and improve abrasion resistance. A thermal head thus formed was actually mounted in a printer and a recording test was conducted. The test showed that fluctuation in record concentration was smaller than a conventional thermal head even in a fine pattern. In addition, an Al electrode was not degraded.

Example 17

Referring to Fig. 15, an embodiment will be described.

On a glass substrate 1' with a height, an AlNa thin film was formed as a resistance exothermic body film 12 by means of a multi-target sputter apparatus as shown in Fig. 2. The sputter conditions are shown below.

Sputter system: RF magnetron system
Target: 100 mmφ Al/Nb binary target
Substrate temperature: Room temperature (25°C)
Sputter gas: Ar
Gas pressure: 0.20Pa
Applied power: 10W/cm$^2$

As a result of composition analysis, it was found that the formed film was $Al_{40}Nb_{60}$. X-ray diffraction revealed that this film was amorphous.

This Al-Nb film was processed by lithography and etching steps to remain only on the height and vicinity thereof. Next this was placed in a chamber again and subjected to Ar bias cleaning. Then an Al film was sputtered. The sputter conditions are shown below.

Sputter system: RF magnetron system
Target: 100 mmφ Al target
Substrate temperature: room temperature (25°C)
Sputter gas: Ar
Gas pressure: 1Pa
Applied power: 5W/cm$^2$

The crystalline properties of the Al film formed on the flat part were evaluated by X-ray diffraction. This film was an oriented film with the FWHM of 1.2° of a (111) rocking curve.

Next this Al film was processed by lithography and etching steps to form electrodes 13, 13'. Further a $SiO_2$ insulative film 14 was coated thereon to prevent oxidation and improve abrasion resistance. The recording test was conducted under the same conditions as Example 16. The test showed the excellent properties.

Example 18

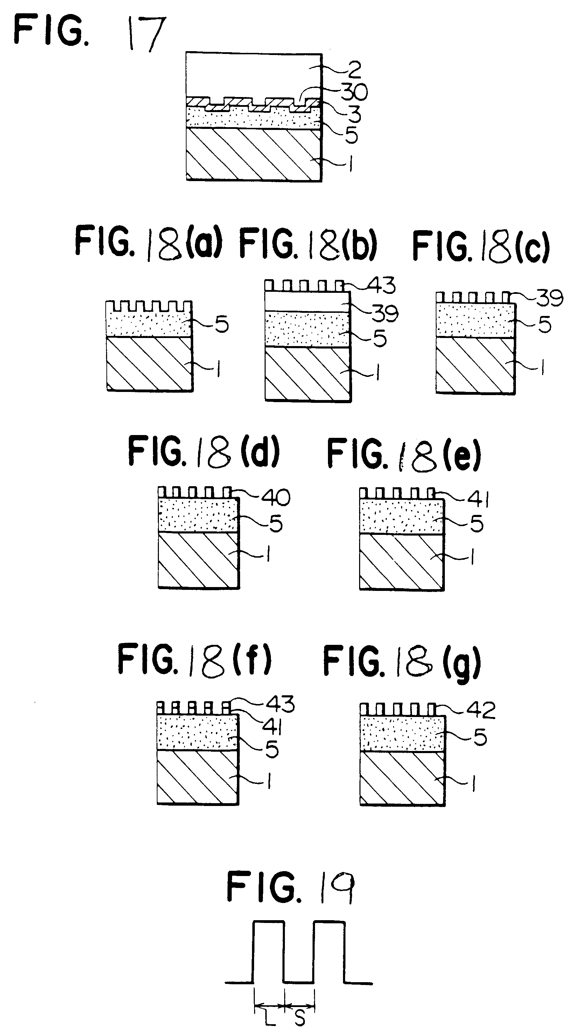

Referring to Fig. 16, an embodiment will be described.

Using a six-inch silicon wafer substrate 1 with a 4000Å insulative oxide layer 5 of a thermal oxide film, an AlTa amorphous film 3 was formed by means of a multi-target sputter apparatus as shown in Fig. 2. The sputter conditions are shown below.

Sputter system: RF magnetron system
Target: 100 mm$\phi$ Al/Ta binary target
Substrate temperature: Room temperature (25°C)
Sputter gas: Ar
Gas pressure: 0.20Pa
Applied power: 10W/cm$^2$
Film thickness: 1000Å

Composition analysis revealed that the formed film was $Al_{45}Ta_{55}$. X-ray diffraction revealed that the film was amorphous.

Next, in the surface of the AlTa amorphous thin film 3, grooves 38 were formed by standard lithography and RIE steps. The depth of the grooves 38 was 100Å and the width thereof was 1000Å.

After the AlTa amorphous thin film 3 with the grooves 38 was subjected to Ar bias cleaning, an Al film was sputtered. The sputter conditions are shown below.

Sputter system: RF magnetron system
Target: 100 mm$\phi$ Al target
Substrate temperature: Room temperature (25°C)
Sputter gas: Ar
Gas pressure: 1Pa
Applied power: 5W/cm$^2$
Film thickness: 4000Å

The Al film thus formed was evaluated for the orientation and crystalline properties by X-ray diffraction. The (111) orientation FWHM was 1.2° and satisfactory crystalline properties were observed.

Further, observation by a transmission electron microscope (TEM) revealed that directions of Al <211> were substantially equal to the longitudinal direction of the grooves 38 formed on the amorphous thin film 3 so that the Al film 2 consisted of only small angle boundaries.

Next, this Al film was processed into a metal wiring for the EM test. Steps for preparing a test sample were as follows: As shown in Fig.12 , a test substrate 24 had an anode 21, a cathode 22 and a 0.8 μm wide wiring part 23 connecting these electrode. The test substrate 24 was made by standard lithography and RIE steps. A current at a current density of $2 \times 10^6$ A/cm$^2$ was flown to the wiring part 23 of the test substrate 24 at a test temperature of 200°C. It was confirmed that even after the elapsed time of 1000 hours there was no failure. This exhibits that since Al film was highly oriented and the Al film was a film formed only of small angle grain boundaries, the electromigration endurance was dramatically enhanced.

Example 19

Referring to Fig. 17, an embodiment will be described.

Using a six-inch silicon wafer substrate 1 with a 4000Å insulative layer 5 of a thermal oxide film, grooves were formed by means of standard lithography and RIE steps.

A NiTa amorphous film 3 with grooves 30 was formed on the substrate 1 by means of a multi-target sputter apparatus as shown in Fig. 2. The sputter conditions are shown below.

Sputter system: RF magnetron system
Target: 100 mm$\phi$ Ni/Ta binary target
Substrate temperature: Room temperature (25°C)
Sputter gas: Ar
Gas pressure: 0.20Pa
Applied power: 10W/cm$^2$
Film thickness: 100Å

Composition analysis revealed that the formed film was $Ni_{50}Ta_{50}$. X-ray diffraction revealed that the film was amorphous. A sectional surface was examined by a SEM. The examination revealed that the grooves 30 were uniformly formed in the surface of NiTa amorphous film 3, the depth of the grooves 30 being 1000Å, the width thereof being 1000Å.

After the NiTa amorphous thin film 3 was subjected to Ar bias cleaning, Al was sputtered in a manner similar to Example 18. The formed Al film was evaluated for the orientation and crystalline properties by X-ray diffraction. The (111) orientation FWHM was 0.9° and satisfactory crystalline properties were observed.

Observation by a transmission electron microscope (TEM) revealed that directions of Al (211) were substantially equal to the longitudinal direction of the grooves formed on the amorphous thin film so that the Al film consisted of only small angle grain boundaries.

Example 20

Using a six-inch silicon wafer substrate with a 4000Å thermal oxide film, an AlNb amorphous thin film was formed by means of a multi-target sputter apparatus as shown in Fig. 2. The sputter conditions are shown below.

Sputter system: RF magnetron system
Target: 100 mmφ Al/Nb binary target
Substrate temperature: Room temperature (25°C)
Sputter gas: Ar
Gas pressure: 0.20Pa
Applied power: 10W/cm$^2$
Film thickness: 1000Å

Composition analysis revealed that the formed film was $Al_{40}Nb_{60}$. X-ray diffraction revealed that the film was amorphous.

In this AlNb amorphous thin film, grooves were formed by standard lithography and RIE steps. The depth of the grooves was 100Å and the width thereof was 1000Å.

After the AlNb amorphous thin film with the grooves was subjected to Ar bias cleaning, Al-0.1at%Cu was sputtered as a metal thin film. The sputter conditions are shown below.

Sputter system: RF magnetron system
Target: 100 mmφ AlCu alloy target
Substrate temperature: Room temperature (25°C)
Sputter gas: Ar
Gas pressure: 1Pa
Applied power: 5W/cm$^2$
Film thickness: 4000Å

The AlCu film thus formed was evaluated for the orientation and crystalline properties by X-ray diffraction. The (111) orientation FWHM was 0.9° and satisfactory crystalline properties were observed. When this film was subjected to thermal treatment at 450°C for 30 minutes, the orientation was further enhanced and the (111) orientation FWHM become 0.7°.

Grain direction in a plane was examined by a transmission electron microscope (TEM). It was found that since the grooves arranged in the amorphous thin film controlled grain direction in a plane, the film was of small angle grain boundaries. Further, a metal wiring was formed in a manner similar to Example 18 for the EM test. Even after the elapse of 1000 hours there was no failure.

Example 21

Referring to Figs.18 and 19, an embodiment will be described.

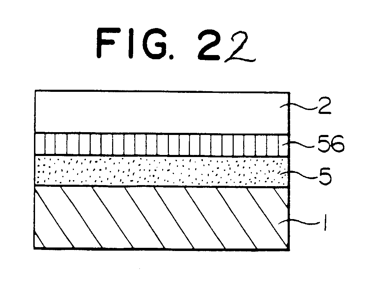

A 1000Å thick thermal oxide film was formed on a Si (100) six-inch substrate 1 as an insulating layer 5. Thereafter, the following seven samples were prepared. In a sample No. 1, the surface of amorphous $SiO_2$ (surface energy: 605erg/cm$^2$) was processed by lithography and RIE steps to form grooves with a depth of 200Å (L/S=0.3/0.3μm) (Fig. 18 (a)). Here, L/S is shown in Fig. 19. In a sample No. 2, polycrystalline Ta (surface energy: 2150erg/cm$^2$) was sputtered on the thermal oxide film to form a 500Å thick Ta film 39. Amorphous $SiO_2$ was sputtered to form a 200Å thick $SiO_2$ film 43, and the $SiO_2$ film 43 was then processed to form grooves with a depth of 200Å (L/S=0.3/0.3μm) (Fig. 18 (b)). In a sample No. 3, polycrystalline Ta was sputtered on the thermal oxide film to form a 200Å thick Ta film 39. Subsequently, the Ta film 39 was processed to form grooves with a depth of 200Å (L/S=0.3/0.3μm) (Fig. 18 (c)). In a sample No. 4,

amorphous $Ni_{62}$-$Nb_{38}$ (surface energy: 1326erg/$cm^2$) was sputtered on the thermal oxide film to form a 200Å thick NiNb film 40. Subsequently, the NiNb film 40 was processed to form grooves with a depth of 200Å (L/S=0.3/0.3μm) (Fig. 18 (d)). In a sample No. 5, amorphous Ta-60at%Al (surface energy: 1640erg/$cm^2$) was sputtered on the thermal oxide film to form a 200Å thick TaAl film 41. Subsequently, the TaAl film 41 was processed to form grooves with a depth of 200Å (L/S=0.3/0.3μm) (Fig. 18 (e)). In a sample No. 6, amorphous Ta-60at%Al was sputtered on the thermal oxide film to form a 100Å thick TaAl film 41. Further amorphous $SiO_2$ was sputtered to form a 100Å thick $SiO_2$ film 43. The $SiO_2$ film 43 and TaAl film 41 were processed to form grooves with a depth of 200Å (L/S=0.3/0.3μm) (Fig. 18 (f)). In a sample No. 7, a 200Å thick polysrystalline Si (surface energy: 730erg/$cm^2$) film 42 was formed on the thermal oxide film. Subsequently, the Si film 42 was processed to form grooves with a depth of 200Å (L/S=0.3/0.3μm) (Fig. 18(g)). The sections of the above samples are shown in Fig. 21. For the each sample, pure Al was deposited on the above under layers at a substrate temperature of 200°C in a thickness of 4000Å and then processed into a four-terminal shape for the EM test. A wiring of a measurement part had the width of 1 μm and length of 2000μm. The EM test was conducted at 150°C in 1 x $10^7$ A/$cm^2$. The results are shown in Table 5.

Table 5

| | No.1 | No.2 | No.3 | No.4 | No.5 | No.6 | No. 7 |
|---|---|---|---|---|---|---|---|
| EM Test | x | x | ◯ | ◎ | ◎ | ◎ | x |
| ◎: no failure up to 1000 hours | | | | | | | |
| ◯: failed between 500 and 1000 hours | | | | | | | |
| x: failure after 500 hours or less | | | | | | | |

Example 19

A 1000Å thick thermal oxide film was formed on Si(100) six-inch substrates and then a 200Å thick Ta-40at%Al film was deposited by sputtering. These samples were processed to form grooves of L/S as shown in Table 6 by RIE. The resultant samples were subjected to Ar plasma etching in a high vacuum sputter whose the degree of vacuum was on the order of $10^{-10}$ Torr so that a surface oxide film of the Al-Ta film surface was removed by Ar plasma etching. Subsequently, a pure Al film was formed in a thickness of 4000A. The EM test was conducted in a manner similar to Example 21. The results are shown in Table 6.

Table 6

| S (μm) / L | L/S and EM test results | | | |
|---|---|---|---|---|
| | 0.1 | 0.2 | 0.5 | 1.0 |
| 0.1 | ◎ | ◎ | ◯ | x |
| 0.2 | ◎ | ◎ | ◯ | x |
| 0.5 | x | ◯ | x | x |
| 1.0 | x | ◯ | x | x |

◎: no failure up to 1000 hours
◯: failed between 500 and 1000 hours
x: failure after 500 hours or less

Example 23

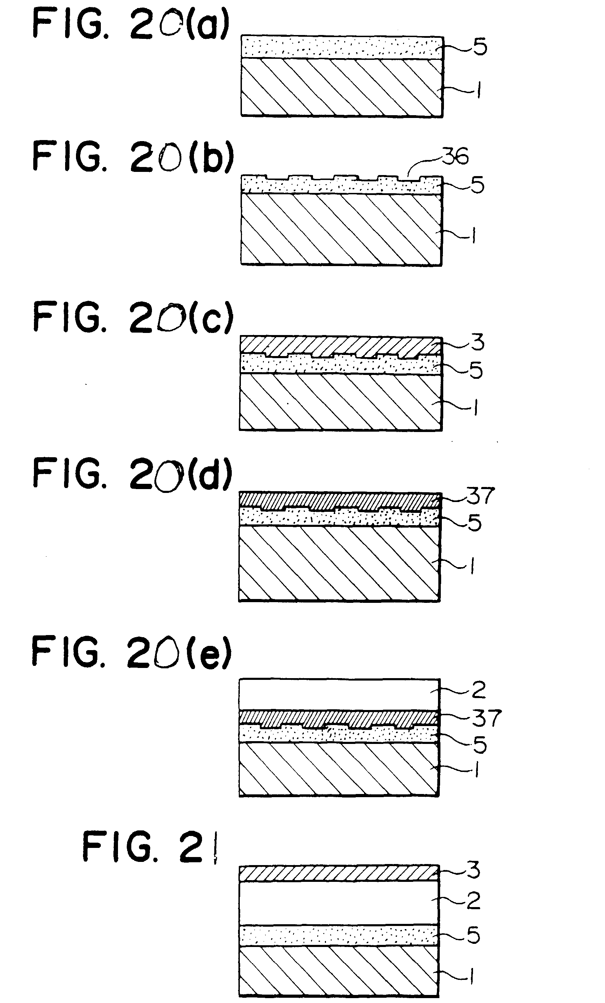

Referring to Fig. 20, an embodiment will be described.

Using a six-inch silicon wafer substrate 1 with a 4000Å insulative layer 5 of a thermal oxide film (Fig. 20 (a)), grooves 36 were formed by standard lithography and RIE steps (Fig.20 (b)). The depth of the grooves 36 was 100Å and the width thereof was 1500Å.

A AlTa amorphous film 3 was formed on this substrate 1 by means of a multi-target sputter apparatus as shown in Fig. 2 (Fig. 20 (c)). The sputter conditions are shown below.

Sputter system: RF magnetron system
Target: 100 mmφ Al/Ta binary target
Substrate temperature: Room temperature (25°C)
Sputter gas: Ar
Gas pressure: 0.20Pa
Applied power: 10W/cm$^2$
Film thickness: 1000Å

Composition analysis revealed that the formed film was $Al_{75}Ta_{25}$. X-ray diffraction revealed that the film was amorphous. Subsequently, this substrate 1 was subjected to thermal treatment at 450°C for 30 minutes so that the AlTa amorphous thin film 3 was crystallized to form an intermetallic compound of $Al_3Ta$ or a polycrystalline film 37 with small angle grain boundaries in a grain diameter of 1 to 2 μm (Fig. 20 (d)). In the same chamber, an Al film was sputtered thereon (Fig. 20 (e)). The sputter conditions are shown below.

Sputter system: RF magnetron system
Target: 100 mmφ Al target
Substrate temperature: Room temperature (25°C)
Sputter gas: Ar
Gas pressure: 1Pa
Applied power: 5W/cm$^2$
Film thickness: 4000Å

The Al film thus formed was evaluated for the orientation and crystalline properties by X-ray diffraction. The (111) orientation FWHM was improved to be 0.3° and almost grain boundaries remaining in the Al film were small angle boundaries.

Next, this Al thin film was processed into a metal wiring 2 for the EM test. Steps for preparing a test sample were as follows: As shown in Fig. 12, a test substrate 24 had an anode 21, a cathode 22 and a 0.8 μm wide wiring part 23 connecting these electrode. The test substrate 24 was made by standard lithography and RIE steps. A current at a current density of $2 \times 10^6$ A/cm$^2$ was loaded to the wiring part 23 of the test substrate 24 at a test temperature of 200°C. Even after the elapsed time of 1000 hours there was no failure. This exhibits that since the Al film was similar to single-crystal, the electromigration endurance was dramatically enhanced.

Example 24

Using a six-inch silicon wafer substrate with a 4000Å thermal oxide film, grooves were formed by standard lithography and RIE steps. The depth of the grooves was 500Å and the width thereof was 5000Å. The space between the grooves was 3000Å.

A AlNb amorphous film was formed on this substrate by means of a multi-target sputter apparatus as shown in Fig. 5. The sputter conditions are shown below.

Sputter system: RF magnetron system
Target: 100 mmφ Al/Nb binary target
Substrate temperature: Room temperature (25°C)
Sputter gas: Ar
Gas pressure: 0.20Pa
Applied power: 10W/cm$^2$
Film thickness: 400Å

Composition analysis revealed that the formed film was $Al_{75}Nb_{25}$. X-ray diffraction revealed that the film was amorphous. Subsequently, this substrate was heated at 450°C for 30 minutes so that the AlNb amorphous film was crystallized to form an intermetallic compound of $Al_3Nb$. The intermetallic compound was filled in the grooves to be of single-crystal. The surface of the resultant substrate was flatted by polishing and then was placed into a chamber again. After Ar bias cleaning, an Al-0.1at%Cu alloy was sputtered as a metal thin film. The sputter conditions are shown below.

Sputter system: RF magnetron system
Target: 100 mmϕ AlCu alloy target
Substrate temperature: Room temperature (25°C)
Sputter gas: Ar
Gas pressure: 1Pa
Applied power: $5W/cm^2$
Film thickness: 4000Å

The AlCu film thus formed was processed into a metal wiring by a RIE step. Moreover, in the EM test under the same conditions as those of Example 23, even after the elapse of 1000 hours there was no failure.

Example 25

Referring to Fig. 21, an embodiment will be described.

As shown in Fig. 21, on a Si wafer substrate 1 where a 1000Å thick thermal oxide film was formed as an insulative layer 5, a 4000Å thick pure Al thin film destined for a metal wiring 2 was formed by sputtering. After the formation of this Al thin film, while keeping vacuum of $1 \times 10^{-7}$ Torr, an Al-Ta amorphous thin film 3 was formed by sputtering using an Al/Ta mosaic target. The thickness of the layer 3 varied 100, 300, and 500Å. At this time, after the formation of this Al thin film, some samples were exposed to the air. The exposed samples were then placed into a sputter apparatus again so that the Al-Ta amorphous thin film 3 was formed on the pure Al thin film. Prior to forming the amorphous thin film 3, a surface oxide of the exposed samples was removed by RF-Ar plasma where the substrate 1 side was an electrode. In the removal of the surface oxide, plasma etching was conducted until a clear diffraction pattern of an Al thin film was observed by RHEED for the surface of the Al thin film. The composition of the amorphous thin film 3 was $Al_{20}Ta_{80}$.

The laminated structure of the metal film 2 of a pure Al and Al-Ta amorphous thin film 3 was thus prepared. In order to examine occurrence frequency of hillocks in the metal film, these thin samples were thermal treated in a forming gas ($N_2$-$H_2$) at 450°C for 30 minutes. Hillock density measured by an optical microscope and tracer type device for measuring a film thickness (α-STEP) are shown in Table 7. As shown in table 7, it was found that the existence of the amorphous thin film 3 considerably reduced the number of hillocks and that even when the thickness of the amorphous thin film 3 was 100Å, this effect could be obtained.

Table 7

|  | Structure of thin film | Thickness of films (Å) | Hillock density after termal treatment |
|---|---|---|---|
| Comparative Example | Al | 4000 | 158/lmm |
| Example | a-AlTa//Al | 500//4000 | 1/1mm |
|  | a-AlTa/ Al | 500 /4000 | 3/1mm |
|  | a-AlTa//Al | 300//4000 | 1/1mm |
|  | a-AlTa/ Al | 300 /4000 | 4/1mm |
|  | a-AlTa//Al | 100//4000 | 2/1mm |
|  | a-AlTa/ Al | 100 /4000 | 5/1mm |
| // means that after a surface oxide was removed by Ar sputtering and the removal was confirmed by RHEED, an amorphous thin film was formed. A height peak of 500Å or more by α-STEP was judged as a hillock and the number of such hillocks was counted. | | | |

Example 26

On a Si wafer substrate where a 1000Å thick thermal oxide film was formed as an insulative layer, a 4000Å thick pure Cu thin film destined for a metal wiring was formed by sputtering. After the formation of this Cu thin film, while keeping vacuum of $1 \times 10^{-7}$ Torr, a Cu-Zr amorphous thin film or a Ni-Nb amorphous thin film was formed by binary target sputtering. The thickness of the amorphous Cu-Zr alloy layer or the amorphous Ni-Nb alloy layer varied 100, 300, and 500Å. At this time, after the formation of this Cu thin film, some samples were exposed to the air. The exposed samples were then placed into a sputter apparatus again so that the Cu-Zr amorphous thin film or the Ni-Nb amorphous thin film was formed on the pure Cu thin film. Prior to forming the amorphous thin film, a surface oxide of the exposed samples was removed by RF-Ar plasma where the substrate side was an electrode. In the removal of the surface oxide, plasma etching was conducted until a clear diffraction pattern of a Cu thin film was observed by RHEED for the surface of the Cu thin film. The composition of the amorphous thin film was $Cu_{50}Zr_{50}$ or $Ni_{65}Nb_{35}$.

In order to examine the oxidization resistance of these thin films in the laminated structure of the metal wiring of the pure Cu thin film, and Cu-Zr or Ni-Nb amorphous thin film, these thin samples were subjected to thermal treatment in the air at 500°C for 30 minutes. Here, Cu and Ni are capable of a continuous series of solid solutions. The results are shown in Table 8. As shown in Table 8, while in the pure Cu thin film the surface become rugged due to volume expansion with increase in the degree of oxidization, in the sample with the laminated Cu-Zr or Ni-Nb amorphous thin film there was no significant difference in evaluation of surface roughness by the use of a tracer type device for measuring a film thickness ($\alpha$-STEP) as shown in Table 8.

Table 8

| | Structure of thin film | Thickness of films (Å) | Average roughness after thermal treatment (Ra, Å) |
|---|---|---|---|
| Comparative Example | Cu | 4000 | 790 |
| Example | a-CuZr//Cu | 500//4000 | 65 |
| | a-CuZr/ Cu | 500 /4000 | 78 |
| | a-CuZr//Cu | 300//4000 | 59 |
| | a-CuZr/ Cu | 300 /4000 | 55 |
| | a-CuZr//Cu | 100//4000 | 67 |
| | a-CuZr/ Cu | 100 /4000 | 72 |
| | a-NiNb//Cu | 500//4000 | 66 |
| | a-NiNb/ Cu | 500 /4000 | 71 |
| | a-NiNb//Cu | 300//4000 | 78 |
| | a-NiNb/ Cu | 300 /4000 | 68 |
| | a-NiNb//Cu | 100//4000 | 59 |
| | a-NiNb/ Cu | 100 /4000 | 61 |
| // means that after a surface oxide was removed by Ar sputtering and the removal was confirmed by RHEED, amorphous thin film was formed. | | | |

Example 27

After a 1000Å $SiO_2$ thermal oxide film was formed on a Si (100) six-inch substrate as an insulative layer, amorphous thin films of compositions as shown in Table 9 were formed by sputtering with the use of a mosaic target or by simultaneous sputtering with the use of a multi target. Subsequently, a 4000Å thick Cu film was formed. Since the various amorphous thin films destined for an underlying layer were exposed to the air, the surface of the amorphous thin films was cleaned by sputter-etching prior to forming the Cu film for the purpose of removing an oxide film on the surface. The conditions of this surface cleaning were an Ar gas pressure of $1.0 \times 10^3$ Torr, a 100MHz RF power output of 100W, a substrate bias voltage of -50V and cleaning time of 4 minutes.

The crystalline properties of the underlying layer was confirmed by RHEED. It was confirmed that the underlying layer was an amorphous thin film.

After the surface cleaning, the Cu film was formed under the following conditions:

degree of vacuum: less than $1 \times 10^{-8}$ Torr
Ar gas pressure: $1.0 \times 10^{-3}$ Torr
100MHZ RF power output: 400W
cathode bias voltage: -300V
film forming speed: 40Å/second.

The crystalline properties of the formed Cu film were evaluated by X-ray. For evaluation of the EM endurance, this was processed into a four-terminal pattern with a wiring width of 1μm and wiring length of 300μm, thereby forming a metal wiring. The electromigration test was then conducted at a current density of $2 \times 10^6$ A/cm$^2$ at a wiring temperature of 300°C. These results are also shown in Table 9 .

As a comparative example, a Cu film was formed directly on a SiO$_2$ thermal oxide film. The comparative example was similarly evaluated. The results are also shown in Table 9.

If an underlying layer may have composition slightly different from those of Table 9as far as the underlying material was amorphous, similar results can be obtained. Further, a little amount of an additive may be added to improve the corrosion resistance, processability and barrier property.

If after forming an amorphous thin film, a Cu film was subsequently formed while keeping vacuum of $1 \times 10^{-8}$ Torr or less, surface cleaning is not necessary.

Table 9

| Underlying material composition (at%) | RHEED | Cu (111) orientation FWHM | Intensity ratio of Cu X-ray I(200)/I(111) | EM endurance |
|---|---|---|---|---|
| Cu75Zr25 | a | 1.5 | - | ◎ |
| Cu50Zr50 | a | 1.5 | - | ◎ |
| Cu60Zr40 | a | 1.8 | - | ◎ |
| Cu30Zr70 | a | 1.7 | - | ◎ |
| Ni35Ta65 | a | 1.7 | - | ◎ |
| W 70Zr30 | a | 1.2 | - | ◎ |
| Ta50Zr50 | a | 1.4 | - | ◎ |
| Mo70Zr30 | a | 1.3 | - | ◎ |
| SiO2 | a | 10.1 | 0.039 | x |
| a: amorphous ◎: even after the elapsed time of 1000 hours, no failure takes place x: within 100 hours, a failure takes place | | | | |

Example 28

Referring to Fig. 22, an embodiment will be described.

100Å thick alloy thin films 56 of TiNb, TiTa, ZrNb, ZrTa, TiW, ZrMo, TiY and ZrY were formed on Si substrates 1 with a 1000Å thick insulative layer 5 of a thermal oxide film by multi-target sputtering system using an Ar gas. An electric power applied to each target was adjusted such that the compositions of the alloy thin films 56 were $Ti_{50}Nb_{50}$, $Ti_{50}Ta_{50}$, $Zr_{50}Nb_{50}$, $Zr_{50}Ta_{50}$, $Ti_{50}W_{50}$, $Zr_{50}Mo_{50}$, $Ti_{50}Y_{50}$, and $Zr_{50}Y_{50}$. Subsequently, keeping vacuum, the gas was replaced with a N$_2$ gas and the surface of the alloy thin film 56 was exposed to N$_2$ plasma by RF discharge where a substrate 1 was an electrode. Then the crystalline properties of the metal thin film 56 was evaluated by RHEED. It was found that an amorphous layer was formed at least on the surface. Auger electron spectroscopy (AES) analysis revealed that the amorphous layer contained the nitrogen. Thus it was supposed that the amorphous layer consisted of amorphous nitride. For comparison, a sample which was not N$_2$ plasma processed was prepared. These alloy thin films thus formed were exposed to the air, and thereafter a 4000Å thick metal film 2 of a pure Al or pure Cu thin films was deposited on the alloy thin films 56. Prior to forming the metal film 2, some thereof were subjected to etching of the alloy thin film 56 surface of an underlying layer by Ar plasma. Next, the crystalline properties of the obtained pure Al or pure Cu thin film were evaluated with the FWHM of Al and Cu (111) rocking curve by X-ray diffraction using a CuKα line. The results are shown in Table 10. As a result, even if the alloy thin films 56 subjected to N$_2$ plasma process were exposed to the air, an Al or Cu thin film 2 with the high (111) crystalline orientation could be formed on the alloy thin films 56 without Ar plasma etching of the surface,

Table 10

| Alloy thin film | N2 plasma process | Ar surface etching | (111) orientation FWHM | |
|---|---|---|---|---|
| | | | Al | Cu |
| TiNb | ○ | ○ | 0.8 | 1.53 |
| | ○ | x | 0.85 | 1.57 |
| | x | ○ | 0.75 | 1.46 |
| | x | x | 6.3 | 8.2 |
| TiTa | ○ | ○ | 0.8 | 1.55 |
| | ○ | x | 0.75 | 1.53 |
| | x | ○ | 0.75 | 1.48 |
| | x | x | 5.9 | 7.5 |
| ZrNb | ○ | ○ | 0.56 | 1.32 |
| | ○ | x | 0.61 | 1.33 |
| | x | ○ | 0.52 | 1.27 |
| | x | x | 6.7 | 8.4 |
| ZrTa | ○ | ○ | 0.66 | 1.44 |
| | ○ | x | 0.68 | 1.53 |
| | x | ○ | 0.72 | 1.37 |
| | x | x | 6.82 | 8.1 |
| TiW | ○ | ○ | 0.72 | 1.54 |
| | ○ | x | 0.75 | 1.43 |
| | x | ○ | 0.93 | 1.72 |
| | x | x | 6.91 | 9.65 |
| ZrMo | ○ | ○ | 0.81 | 1.73 |
| | ○ | x | 0.79 | 1.67 |
| | x | ○ | 0.89 | 1.88 |
| | x | x | 5.69 | 8.71 |
| TiY | ○ | ○ | 0.77 | 1.42 |
| | ○ | x | 0.75 | 1.39 |
| | x | ○ | 0.81 | 1.45 |
| | x | x | 4.29 | 7.21 |
| ZrY | ○ | ○ | 0.63 | 1.12 |
| | ○ | x | 0.70 | 1.08 |
| | x | ○ | 0.71 | 1.05 |
| | x | x | 4.60 | 6.81 |
| ○: conducted      x: non-conducted | | | | |

Example 29

100Å thick thin films of carbide alloys as shown in Table 11 were formed on a Si substrate 1 with a 1000Å thick insulative layer of a thermal oxide film by multi-target sputtering system using metal targets and a carbon target. An electric power applied to each target was adjusted such that the compositions of the carbide alloy thin films become those as shown in Table 11. Then the crystalline properties of the thin film surface was evaluated by RHEED to obtain halo pattern suggesting that this was amorphous. The carbide alloy thin film thus obtained were exposed to the air, and thereafter a 4000Å thick metal wiring of a pure Al or pure Cu thin films was formed on these carbide alloy thin films. Prior to forming the metal films, some thereof were subjected to etching of the carbide alloy thin film furface of an underlying layer by Ar plasma. The crystalline properties of the pure Al or pure Cu thin film were evaluated with the FWHM of Al and Cu (111) rocking curve by X-ray diffraction using a CuK$\alpha$ line. The results are shown in Table 16. As a result, even if the carbide alloy thin films were exposed to the air and the surface thereof was not previously subjected to Ar plasma etching, the Al or Cu thin film with the high (111) crystalline orientation could be formed on the carbide alloy thin films.

Table 11

| Carbide alloy thin film | Ar surface etching | (111) orientation FWHM | |
|---|---|---|---|
| | | Al | Cu |
| TiNbC2 | ○ | 0.9 | 1.45 |
| | x | 0.92 | 1.62 |
| TiTaC2 | ○ | 0.58 | 1.23 |
| | x | 0.55 | 1.21 |
| ZrNbC2 | ○ | 0.54 | 1.22 |
| | x | 0.63 | 1.33 |
| ZrTaC2 | ○ | 0.78 | 1.41 |
| | x | 0.82 | 1.55 |
| TiWC2 | ○ | 0.73 | 1.43 |
| | x | 0.74 | 1.35 |
| ZrMoC2 | ○ | 0.82 | 1.73 |
| | x | 0.77 | 1.67 |
| ○: conducted x: non-conducted | | | |

Example 30

A six-inch silicon wafer with a 4000Å thermal oxide film was used as a substrate. An AlTa film was formed by means of a multi-target sputter apparatus as shown in Fig. 2. The sputter conditions are shown below.

Sputter system: RF magnetron system
Target: 100 mm$\phi$ Al/Ta binary target
Substrate temperature: Room temperature (25°C)
Sputter gas: Ar
Gas pressure: 0.20Pa
Applied power: 10W/cm$^2$
Film thickness: 50Å

Composition analysis revealed that the formed film was $Al_{25}Ta_{75}$. X-ray diffraction revealed that the film was amorphous.

Next, Al was sputtered on the amorphous AlTa thin film as a conductive thin film. The sputter conditions are shown below.

Sputter system: RF magnetron system
Target: 100 mm$\phi$ Al target
Substrate temperature: Room temperature (25°C)
Sputter gas: Ar
Gas pressure: 1Pa

Applied power: 5W/cm$^2$
Film thickness: 4000Å

The Al film thus formed was evaluated for the orientation by X-ray diffraction. It was found that the Al film was a (111) orientated film where the FWHM of an Al (111) peak rocking curve was 1.0°. When this thin film was subjected to thermal treatment at 300°C for 15 minutes, the FWHM was improved to be 0.8°. Further when this thin film was subjected to thermal treatment at 500°C for 15 minutes, the amorphous underlying layer reacted with the conductive thin film to form Al$_3$Ta phase and the amorphous thin film layer disappeared. However, it was found that the specific resistance was unchanged and orientation of the conductive thin film were further improved to be 0.6°, and the highly orientated film was formed on the thermal oxide film.

Next, this conductive thin film was processed into a wiring for the EM test. Steps for preparing a test sample were as follows: As shown in Fig. 12, a test substrate 24 had an anode 21, a cathode 22 and a 0.8 μm wide wiring part 23 connecting these electrode. The test substrate 24 was made by standard lithography and RIE steps. An electrical current of 2 x 10$^6$ A/cm$^2$ was loaded to the wiring part 23 of the test substrate 24 at a test temperature of 200°C. It was confirmed that even after the elapsed time of 1000 hours there was no failure. This exhibits that since (111) orientation of the Al thin film which was the conductive thin film was improved, the electromigration endurance was dramatically enhanced.

Example 31

A six-inch silicon wafer with a 4000Å thermal oxide film was used as a substrate. An AlNb film was formed by means of a multi-target sputter apparatus. The sputter conditions are shown below.

Sputter system: RF magnetron system
Target: 100 mmφ Al/Nb binary target
Substrate temperature: Room temperature (25°C)
Sputter gas: Ar
Gas pressure: 0.20Pa
Applied power: 10W/cm$^2$
Film thickness: 500Å

Composition analysis revealed that the formed film was Al$_{75}$Nb$_{25}$. X-ray diffraction revealed that the film was amorphous. Al was sputtered on the amorphous Al$_{75}$Nb$_{25}$ thin film as a conductive thin film in similar manner to Example 30. The Al film thus formed was evaluated for the orientation by X-ray diffraction. It was found that the Al film was a (111) orientated film where the FWHM of a rocking curve was 1.5°. Further, this thin film was subjected to thermal treatment at 400°C for 15 minutes. As a result, the amorphous thin film layer was crystallized and the amorphous thin film layer disappeared. At the same time the FWHM was improved to be 0.9°. The EM test was conducted under the same conditions as those of Example 30. Even after the elapsed time of 1000 hours there was no failure.

Example 32

A six-inch silicon wafer with a 4000Å thermal oxide film was used as a substrate. A CuTi film was formed by means of a multi-target sputter apparatus similar to Example 30. The sputter conditions are shown below.

Sputter system: RF magnetron system
Target: 100 mmφ Cu/Ti binary target
Substrate temperature: Room temperature (25°C)
Sputter gas: Ar
Gas pressure: 0.20Pa
Applied power: 10W/cm$^2$
Film thickness: 500Å

Composition analysis revealed that the formed film was Cu$_{50}$Ti$_{50}$. X-ray diffraction revealed that the film was amorphous. This amorphous CuTi thin film was exposed to the air and thereafter cleaned by Ar plasma. An Al-0.1at%Cu alloy was sputtered as a conductive thin film. The sputter conditions are shown below.

Sputter system: RF magnetron system
Target: 100 mmφ AlCu alloy target (Cu 0.1atm%)

Substrate temperature: Room temperature (25°C)
Sputter gas: Ar
Gas pressure: 1Pa
Applied power: 5W/cm$^2$
Film thickness: 4000Å

The AlCu film thus formed was evaluated for the orientation by X-ray diffraction. It was found that the AlCu film was a (111) oriented film where the FWHM of a rocking curve was 0.9°. Further, this thin film was subjected to thermal treatment at 400°C for 15 minutes. As a result, the amorphous thin film layer was crystallized and the amorphous thin film layer disappeared. At the same time, the (111) orientation of the AlCu film was further improved and the FWHM become 0.6°.

Example 33

A TiN/Ti layer was formed on a six-inch silicon wafer as a diffusion prevention layer. An AlTa film was formed thereon by sputtering. The sputter conditions are shown below.

Sputter system: RF magnetron system
Target: 100 mmφ Al/Ta binary target
Substrate temperature: Room temperature (25°C)
Sputter gas: Ar
Gas pressure: 0.20Pa
Applied power: 10W/cm$^2$
Film thickness: 100Å

Composition analysis revealed that the formed film was $Al_{40}Ta_{60}$. X-ray diffraction revealed that the film was amorphous. Al was sputtered on the amorphous AlTa film as a conductive thin film under the same conditions as those of Example 30. The Al film thus formed was evaluated for the orientation by X-ray diffraction. It was found that the Al film was a (111) oriented film where the FWHM of a rocking curve was 1.3°. Further, this thin film was subjected to thermal treatment at 500°C for 15 minutes. As a result, the amorphous thin film layer reacted with the conductive thin film to form $Al_3Ta$ phase and the amorphous thin film layer disappeared. However, the specific resistance was not increased and orientation of the conductive thin film were improved and the FWHM become 0.8°. This exhibited that the TiN/Ti layer suppressed reaction with silicon. The EM test was conducted under the same conditions as those of Example 30. Even after the elapsed time of 1000 hours there was no failure.

Example 34

A six-inch silicon wafer with a 4000Å thermal oxide film was used as a substrate. A 100Å thick amorphous $V_xAl_{100-x}$, $Nb_xAl_{100-x}$, $Ta_xAl_{100-x}$, $Mo_xAl_{100-x}$, or $W_xAl_{100-x}$ layer was formed on the substrate by means of a multi-sputter apparatus of Example 49 while controlling electric power to be applied to a target of Al, and V, Nb, Ta, Mo or W. Compositions of these amorphous layers are shown in Table 12. It was confirmed by X-ray diffraction that each layer was amorphous. As shown in Table 12, if the atomic concentration of V, Nb, Ta, Mo or W was extremely high or low in the amorphous layer, an inherent halo peak of amorphous state was not observed. These samples were placed in the sputter apparatus again, and then cleaned by Ar plasma. Thereafter a pure Al film was deposited in a thickness of 4000Å. The (111) orientation FWHM of the deposited Al thin film was evaluated by X-ray diffraction. The results are also shown in Table 12. An ability of the amorphous layer to control (111) orientation was confirmed. Subsequently, these thin films were processed by standard PEP and RIE steps into a pattern with a 0.8μm wide wiring as shown in Fig. 12 for the electromigration (EM) accelerated test. The EM accelating test was conducted under conditions, a test temperature of 200°C, a current density of $2 \times 10^6$ A/cm$^2$. When the electric resistance of the wiring increased by 10% of the resistance just after the test started, it was judged that this increase was a wiring failure. As apparent from Table 12, in the Al wirings of the invention which were formed on the amorphous underlying films, no failure was observed even after the elapsed time of 1000 hours. This shows that the Al wirings of the invention had the high electromigration endurance. As a comparative example, Al was formed directly on the thermal oxide film without deposition of an amorphous under film, and processed into the same pattern for the EM accelating test. Under the same test conditions, in these comparative examples, failures were observed within 10 hours.

# EP 0 594 286 B1

Table 12

| $V_xAl_{100-x}$ | | | | | | | | | |
|---|---|---|---|---|---|---|---|---|---|
| Underlying film composition, X | 10 | 20 | 30 | 40 | 50 | 60 | 70 | | |
| Existence of halo peak | x | ○ | ○ | ○ | ○ | ○ | x | | |
| Al(111) FWHM | 6.6° | 2.6° | 2.0° | 1.5° | 1.3° | 1.5° | 7.0° | | |
| EM endurance | x | △ | △ | ○ | ○ | ○ | x | | |
| $Nb_xAl_{100-x}$ | | | | | | | | | |
| Underlying film composition, X | 10 | 20 | 30 | 40 | 50 | 70 | 80 | 85 | 90 |
| Existence of halo peak | x | ○ | ○ | ○ | ○ | ○ | ○ | ○ | x |
| Al(111) FWHM | 6.4° | 2.6° | 1.5° | 1.2° | 1.1° | 1.0° | 1.6° | 2.0° | 6.5° |
| EM endurance | x | △ | ○ | ○ | ○ | ○ | ○ | △ | x |
| $Ta_xAl_{100-x}$ | | | | | | | | | |
| Underlying film composition, X | 10 | 20 | 30 | 50 | 70 | 80 | 85 | 90 | |
| Existence of halo peak | x | ○ | ○ | ○ | ○ | ○ | ○ | x | |
| Al(111) FWHM | 6.3° | 2.5° | 1.8° | 1.5° | 1.1° | 1.0° | 1.5° | 6.2° | |
| EM endurance | x | △ | ○ | ○ | ○ | ○ | ○ | x | |
| $Mo_xAl_{100-x}$ | | | | | | | | | |
| Underlying film composition, X | 20 | 25 | 30 | 45 | 60 | 70 | 80 | 90 | |
| Existence of halo peak | x | ○ | ○ | ○ | ○ | ○ | ○ | x | |
| Al(111) FWHM | 7.0° | 2.7° | 2.0° | 1.7° | 1.5° | 1.3° | 2.8° | 10.0° | |
| EM endurance | x | △ | △ | ○ | ○ | ○ | △ | x | |
| $W_xAl_{100-x}$ | | | | | | | | | |
| Underlying film composition, X | 10 | 15 | 20 | 30 | 40 | 50 | 60 | | |
| Existence of halo peak | x | ○ | ○ | ○ | ○ | ○ | x | | |
| Al(111) FWHM | 6.5° | 2.8° | 1.9° | 1.8° | 1.5° | 1.1° | 8.0° | | |
| EM endurance | x | △ | ○ | ○ | ○ | ○ | x | | |

FWHM : Full Width at Half Maximum

EM endurance :

(Test temperature, 200°C; Current density, $2 \times 10^6$ A/cm$^2$)

Endurance of 1000 hours or more ; ○

Endurance of 500 hours or more, but not more than 1000 hours ; △

Endurance of 500 or less ; x

Composition in at% unit.

Example 35

A 1000Å thick thermal oxide film was formed on a Si (100) six-inch substrate. Films of various alloy compositions as shown in Table 13 (a) to (n) were formed in a thickness of 1000Å by using a mosaic target or multi-simultaneous sputtering. Keeping vacuum, a Cu film was continuously formed in a thickness of 4000Å and then subjected to thermal treatment at 450°C for 30 minutes. A rocking curve of Cu (111) Cu was measured by X-ray diffraction to examine the crystal orientation of the Cu film thus formed. The FWHMs were shown in Table 13 (a) to (n).

For examining the crystalline properties of underlying films, samples fabricated only with the underlying materials were evaluated by X-ray diffraction. It was confirmed whether or not a halo peak caused by amorphous state existed.

Conditions for the Cu film formation were shown below.

Degree of vacuum: Less than $1 \times 10^{-7}$ Torr
Ar gas pressure: $1.0 \times 10^{-3}$ Torr
100MHz rf output power: 400W
Cathode bias voltage: -300V
Film deposition rate: 40Å/second

The composition of an underlying film which was formed by using a target of the poor purity was 3N in the worst case. An element of the same group (for example, Ta against Nb) was mainly contained as impurities, and it was difficult that the element was isolated at the time of purification. However, this adversely effects neither amorphous formability of the underlying film nor the crystal orientation of Cu thereon.

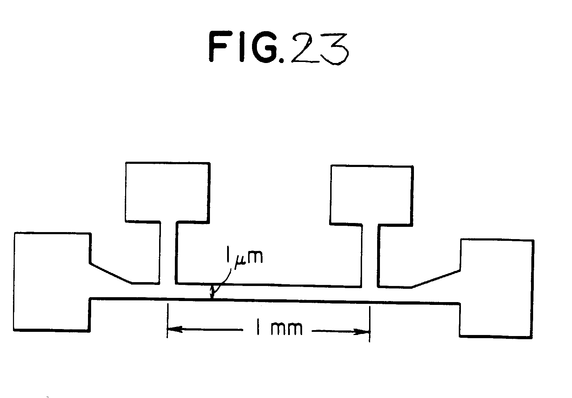

For examining the reliability of the Cu wiring, a 3μm thick $SiO_2$ film was formed on the Si substrate, and then the groove of a four-terminal electric resistance measurement pattern was provided on the $SiO_2$ film as shown in Fig. 23 by PEP and RIE steps. A resistance measurement part had groove 1.0μm wide, 4500Å deep and Imm long.

After the above $SiO_2$ processing, the various under films were formed in a thickness of 500Å by collimated sputtering. Subsequently a Cu film was formed in a thickness of 6000Å and subjected to thermal treatment at 450°C for 30 minutes. Excess Cu was removed by chemical-mechanical polishing (CMP) to obtain a sample for a reliability test.

The reliability test was conducted at a test temperature of 300°C at a current density of $2 \times 10^6$ A/cm$^2$ under vacuum. The results were also shown in Table 13. If the electrical resistance of the wiring after the thermal treatment was converted to specific resistance value, the value was about 1.7 μΩcm. This value was substantially the same as a bulk value of Cu. Accordingly this indicated that the thermal treatment did not cause reaction between the underlying film and Cu. Further, although the thermal treatment of this example was conducted under vacuum, the thermal treatment may be conducted at a hydrogen atmosphere or, a mixture of hydrogen and nitrogen gas (forming gas). Moreover, although in this example a Cu film was formed continuously after the formation of an under film, the Cu film does not need to be formed just after the formation of the under film. That is, after the formation of the under film, the sample may be exposed to the air and subjected to plasma cleaning of the under film surface in vacuum for removing a natural oxide film, followed the formation of the Cu film.

One of Ti, Zr, Hf, V, Nb, Ta or Cr elements was added to the underlying film in the amount of 1 to 10 at% keeping the amorphous formability. After the formation of Cu wiring, the sample was heated to 600 to 750°C at a $NH_3$ or $N_2$ atmosphere to form a nitride film on the Cu wiring surface and in the interface between the underlying film and Cu film. As a result, even after a formation of a TEOS insulative film, the electrical resistance did not increase and the oxidation of Cu wiring was remarkably reduced.

If bias of -20 to -50V was applied to a substrate at the time of forming a Cu film, the orientation of the Cu film was improved and a composition range allowing excellent EM endurance was enlarged, as shown in Table 18 (m) (a substrate bias was -30V).

As comparative samples, results of Cu films without an under film were shown in Table 13 (l) and (m).

Table 13 (a)

| Ti$_x$Cu$_{100-x}$ | | | | | | |
|---|---|---|---|---|---|---|
| Underlying film composition,X | 10 | 18 | 30 | 50 | 70 | 80 |
| Existence of halo peak | x | ○ | ○ | ○ | ○ | x |
| Cu film FWHM | 7.2° | 1.6° | 1.4° | 1.1° | 1.0° | 7.8° |
| EM endurance | x | ○ | ○ | ○ | ○ | x |

Table 13 (b)

| Zr$_x$Cu$_{100-x}$ | | | | | | |
|---|---|---|---|---|---|---|
| Underlying film composition,X | 10 | 18 | 30 | 50 | 70 | 80 |
| Existence of halo peak | x | ○ | ○ | ○ | ○ | x |
| Cu film FWHM | 7.2° | 1.2° | 1.0° | 1.0° | 0.9° | 6.5° |
| EM endurance | x | ○ | ○ | ○ | ○ | x |

Table 13 (c)

| Hf$_x$Cu$_{100-x}$ | | | | | | |
|---|---|---|---|---|---|---|
| Underlying film composition,X | 10 | 20 | 40 | 50 | 70 | 80 |
| Existence of halo peak | x | ○ | ○ | ○ | ○ | x |
| Cu film FWHM | 6.5° | 1.2° | 1.0° | 0.9° | 0.9° | 6.7° |
| EM endurance | x | ○ | ○ | ○ | ○ | x |

Table 13 (d)

| Y$_x$Cu$_{100-x}$ | | | | | | | |
|---|---|---|---|---|---|---|---|
| Underlying film composition,X | 5 | 10 | 12 | 33 | 50 | 53 | 60 |
| Existence of halo peak | x | ○ | ○ | ○ | ○ | ○ | x |
| Cu film FWHM | 7.0° | 3.4° | 1.4° | 1.4° | 1.1° | 1.0° | 7.2° |
| EM endurance | x | Δ | ○ | ○ | ○ | ○ | x |

Table 13 (e)

| V$_x$Co$_{100-x}$ | | | | | | | |
|---|---|---|---|---|---|---|---|
| Underlying film composition,X | 10 | 15 | 25 | 50 | 70 | 80 | 90 |
| Existence of halo peak | x | ○ | ○ | ○ | ○ | ○ | x |
| Cu film FWHM | 6.8° | 1.9° | 1.3° | 1.5° | 1.2° | 1.7° | 5.8° |
| EM endurance | x | ○ | ○ | ○ | ○ | ○ | x |

Table 13 (f)

| Nb$_x$Cr$_{100-x}$ | | | | | | |
|---|---|---|---|---|---|---|
| Underlying film composition,X | 20 | 25 | 35 | 40 | 45 | 60 |
| Existence of halo peak | x | ○ | ○ | ○ | ○ | x |
| Cu film FWHM | 6.1° | 1.6° | 1.0° | 1.1° | 1.5° | 7.2° |
| EM endurance | x | ○ | ○ | ○ | ○ | x |

Table 13 (g)

| Co$_x$Nb$_{100-x}$ | | | | | | | |
|---|---|---|---|---|---|---|---|
| Underlying film composition,X | 30 | 40 | 45 | 60 | 70 | 78 | 85 |
| Existence of halo peak | x | ○ | ○ | ○ | ○ | ○ | x |
| Cu film FWHM | 2.8° | 2.5° | 1.0° | 1.1° | 1.2° | 1.8° | 6.5° |
| EM endurance | Δ | Δ | ○ | ○ | ○ | ○ | x |

Table 13 (h)

| Ta$_x$Cr$_{100-x}$ | | | | | | |
|---|---|---|---|---|---|---|
| Underlying film composition,X | 20 | 25 | 35 | 40 | 45 | 60 |
| Existence of halo peak | x | ○ | ○ | ○ | ○ | x |

Table 13 (h)   (continued)

| $Ta_xCr_{100-x}$ | | | | | | |
|---|---|---|---|---|---|---|
| Underlying film composition,X | 20 | 25 | 35 | 40 | 45 | 60 |
| Cu film FWHM | 6.9° | 1.8° | 1.0° | 0.9° | 2.6° | 6.5° |
| EM endurance | x | ○ | ○ | ○ | Δ | x |

Table 13 (i)

| $Ta_xCo_{100-x}$ | | | | | | | |
|---|---|---|---|---|---|---|---|
| Underlying film composition,X | 20 | 25 | 33 | 40 | 45 | 50 | 60 |
| Existence of halo peak | x | ○ | ○ | ○ | ○ | ○ | x |
| Cu film FWHM | 6 ° | 1.1° | 0.8° | 1.0° | 1.2° | 2.7° | 7.8° |
| EM endurance | x | ○ | ○ | ○ | ○ | Δ | x |

Table 13 (j)

| $Cr_xCo_{100-x}$ | | | | | |
|---|---|---|---|---|---|
| Underlying film composition,X | 45 | 50 | 60 | 70 | 80 |
| Existence of halo peak | x | ○ | ○ | ○ | x |
| Cu film FWHM | 7.2° | 1.9° | 1.3° | 1.8° | 6.2° |
| EM endurance | x | ○ | ○ | ○ | x |

Table 13 (k)

| $MO_xCO_{100-x}$ | | | | | | |
|---|---|---|---|---|---|---|
| Underlying film composition,X | 10 | 20 | 35 | 45 | 60 | 80 |
| Existence of halo peak | x | ○ | ○ | ○ | ○ | x |
| Cu film FWHM | 6.5° | 1.0° | 0.9° | 0.8° | 1.2° | 6.2° |
| EM endurance | x | ○ | ○ | ○ | ○ | x |

Table 13 (l)

| $V_xCO_{100-x}$ | | | | | | | | |
|---|---|---|---|---|---|---|---|---|
| Underlying film composition,X | 15 | 20 | 35 | 45 | 60 | 70 | 90 | on SiO2 |
| Existence of halo peak | x | ○ | ○ | ○ | ○ | ○ | x | x |
| Cu film FWHM | 5.0° | 1.0° | 0.9° | 0.8° | 1.0° | 2.5° | 7.0° | 9.0° |
| EM endurance | x | ○ | ○ | ○ | ○ | Δ | x | x |

Table 13 (m)

| $W_xCo_{100-x}$ | | | | | | | | |
|---|---|---|---|---|---|---|---|---|
| Underlying film composition,X | 15 | 20 | 35 | 45 | 60 | 70 | 90 | on SiO2 |
| Existence of halo peak | x | ○ | ○ | ○ | ○ | ○ | x | x |
| Cu film FWHM | 2.8° | 0.6° | 0.5° | 0.5° | 0.6° | 1.8° | 6.2° | 7.0° |

Table 13 (m)  (continued)

| W$_x$Co$_{100-x}$ | | | | | | | | |
|---|---|---|---|---|---|---|---|---|
| Underlying film composition,X | 15 | 20 | 35 | 45 | 60 | 70 | 90 | on SiO2 |
| EM endurance | Δ | ○ | ○ | ○ | ○ | ○ | x | x |

Table 13 (n)

| Ta$_x$Cu$_{100-x}$ | | | | | | |
|---|---|---|---|---|---|---|
| Underlying film composition,X | 10 | 20 | 40 | 60 | 80 | 90 |
| Existence of halo peak | x | ○ | ○ | ○ | ○ | x |
| Cu film FWHM | 7.6° | 1.5° | 1.1° | 1.0° | 1.4° | 7.2° |
| EM endurance | x | ○ | ○ | ○ | ○ | x |

Table 13 (a) to 13 (n)

FWHM :           Full Width at Half Maximum
EM endurance :   (Test temperature, 300°C; Current density, $2 \times 10^6$ A/cm$^2$)
                 Endurance of 1000 hours or more ; ○
                 Endurance of 500 hours or more, but not more than 1000 hours ; Δ
                 Endurance of 500 or less ; x

Composition in at% unit.

## Claims

1.  An electronic device comprising:

    an amorphous thin film formed on a substrate, said amorphous thin film having ordered structure over a short range; and
    a metal wiring having crystalline structure formed directly on the surface of the amorphous thin film;
    wherein the interatomic distance of the ordered structure of the amorphous thin film approximately matches the spacing of those crystal planes of the metal wiring which include atoms separated by the first-nearest interatomic distance.

2.  The electronic device of claim 1, wherein an insulative layer or a barrier layer is interposed between the substrate and the amorphous thin film.

3.  The electronic device of claim 1, wherein grooves are provided on the surface of the amorphous thin film.

4.  The electronic device of claim 1, wherein the metal wiring is mainly made of one metal selected from the group consisting of Al, Cu, Au, Ag and W.

5.  The electronic device of claim 1, wherein the metal wiring is mainly formed of one material selected from fcc structured pure Al, pure Cu, pure Au, pure Ag, an Al-Cu alloy, an Al-Ti alloy, an Al-Cr alloy, an Al-Ta alloy, an Al-Mg alloy, an Al-In alloy, an Al-Li alloy, a Cu-Be alloy, a Cu-Ag alloy, an Au-Pt alloy, an Au-Ag alloy, an Au-Pd alloy, an Au-Cu alloy, and bcc structured pure W.

6.  The electronic device of claim 5, wherein the metal wiring is mainly formed of one of the alloys and wherein the metal wiring further comprises Si in an amount of 1wt% or less.

7.  The electronic device of claim 1, wherein the surface energy of the crystalline phase of the material forming the amorphous thin film is larger than the surface energy of a material forming the metal wiring.

8. The electronic device of claim 1, wherein the amorphous thin film contains at least one element selected from the metal element mainly forming the metal wiring, an element capable of forming an intermetallic compound with the metal element mainly forming the metal wiring, and an element capable of forming continuous series of solid solution in the metal element mainly forming the metal wiring.

9. The electronic device of claim 5, wherein the amorphous thin film contains at least two elements selected from the metal element mainly forming the metal wiring, III A group elements, IV A group elements, V A group elements, VI A group elements, VIII groups elements, B, C, N, O, P, Si, and Ge.

10. The electronic device of claim 4, wherein the metal element mainly forming the metal wiring is Al, and the amorphous thin film is formed of one alloy selected from $Ta_xAl_{1-x}(0.20 \leq x \leq 0.85)$, $Nb_xAl_{1-x}(0.2 \leq x \leq 0.85)$, $V_xAl_{1-x}$ ($0.2 \leq x \leq 0.60$), $W_xAl_{1-x}$ ($0.15 \leq x \leq 0.50$), and $Mo_xAl_{1-x}$ ($0.25 \leq x \leq 0.80$).

11. The electronic device of claim 4, wherein the metal element mainly forming the metal wiring is Cu, and the amorphous thin film is formed of one alloy selected from $V_xCo_{1-x}$ ($0.15 \leq x \leq 0.80$), $Nb_xCr_{1-x}$ ($0.25 \leq x \leq 0.45$), $Nb_xCo_{1-x}$ ($0.22 \leq x \leq 0.55$), $Ta_xCr_{1-x}$ ($0.25 \leq x \leq 0.40$), $Ta_xCo_{1-x}$ ($0.25 \leq x \leq 0.45$), $Cr_xCo_{1-x}$ ($0.50 \leq x \leq 0.70$), $Mo_xCo_{1-x}$ ($0.20 \leq x \leq 0.60$), $W_xCo_{1-x}$ ($0.20 \leq x \leq 0.60$), $Ti_xCu1_{-x}$ ($0.18 \leq x \leq 0.70$), $Zr_zCu_{1-x}$ ($0.18 \leq x \leq 0.70$), $Hf_xCu_{1-x}$ ($0.20 \leq x \leq 0.70$), $Y_xCu_{1-x}$ ($0.10 \leq x \leq 0.53$), and $Ta_xCu_{1-x}$ ($0.20 \leq x \leq 0.80$).

## Patentansprüche

1. Elektronische Vorrichtung mit:

   einem amorphen Dünnfilm, welcher auf einem Substrat gebildet ist, wobei der amorphe Dünnfilm eine über einen kurzen Bereich geordnete Struktur aufweist; und

   einer Metallverdrahtung mit einer kristallinen Struktur, welche direkt an der Oberfläche des amorphen Dünnfilms gebildet ist;

   wobei der interatomare Abstand der geordneten Struktur des amorphen Dünnfilms ungefähr mit dem Abstand der Kristallebenen der Metallverdrahtung übereinstimmt, welche Atome aufweisen, die um den nächstbenachbarten interatomaren Abstand getrennt sind.

2. Elektronische Vorrichtung nach Anspruch 1, wobei eine Isolationsschicht oder eine Barrierenschicht zwischen das Substrat und den amorphen Dünnfilm gesetzt ist.

3. Elektronische Vorrichtung nach Anspruch 1, wobei Nuten an der Oberfläche des amorphen Dünnfilms vorgesehen sind.

4. Elektronische Vorrichtung nach Anspruch 1, wobei die Metallverdrahtung hauptsächlich aus einem Metall gebildet ist, welches aus folgender Gruppe ausgewählt ist: Al, Cu, Au, Ag und W.

5. Elektronische Vorrichtung nach Anspruch 1, wobei die Metallverdrahtung hauptsächlich aus einem Material gebildet ist, das ausgewählt ist aus: fcc-strukturiertem reinem Al, reinem Cu, reinem Au, reinem Ag, einer Al-Cu-Legierung, einer Al-Ti-Legierung, einer Al-Cr-Legierung, einer Al-Ta-Legierung, einer Al-Mg-Legierung, einer Al-In-Legierung, einer Al-Li-Legierung, einer Cu-Be-Legierung, einer Cu-Ag-Legierung, einer Au-Pt-Legierung, einer Au-Ag-Legierung, einer Au-Pd-Legierung, einer Au-Cu-Legierung und bcc-strukturiertem reinem W.

6. Elektronische Vorrichtung nach Anspruch 5, wobei die Metallverdrahtung hauptsächlich aus einer der Legierungen gebildet ist und wobei die Metallverdrahtung weiterhin Si in einer Menge von 1 Gew.-% oder weniger aufweist.

7. Elektronische Vorrichtung nach Anspruch 1, wobei die Oberflächenenergie der kristallinen Phase des Materials zum Bilden des amorphen Dünnfilms größer ist als die Oberflächenenergie eines Materials zum Bilden der Metallverdrahtung.

8. Elektronische Vorrichtung nach Anspruch 1, wobei der amorphe Dünnfilm zumindest ein Element enthält, das ausgewählt ist aus dem Metallelement, das hauptsächlich die Metallverdrahtung bildet, einem Element, das in der Lage ist, eine intermetallische Verbindung mit dem Metallelement, das hauptsächlich die Metallverdrahtung bildet, zu bilden, und einem Element, das in der Lage ist, eine kontinuierliche Reihe einer Feststofflösung in dem Metallelement, das hauptsächlich die Metallverdrahtung bildet, zu bilden.

9. Elektronische Vorrichtung nach Anspruch 5, wobei der amorphe Dünnfilm zumindest zwei Elemente enthält, die ausgewählt sind aus dem Metallelement, das hauptsächlich die Metallverdrahtung bildet, III-A-Gruppe-Elementen, IV-A-Gruppe-Elementen, V-A-Gruppe-Elementen, VI-A-Gruppe-Elementen, VIII-Gruppe-Elementen, B, C, N, O, P, Si und Ge.

10. Elektronische Vorrichtung nach Anspruch 4, wobei das Metallelement, das hauptsächlich die Metallverdrahtung bildet, Al ist, und der amorphe Dünnfilm aus einer Legierung gebildet ist, die ausgewählt ist aus:
$Ta_xAl_{1-x}(0,20 \le x \le 0,85)$, $Nb_xAl_{1-x}(0,2 \le x \le 0,85)$, $V_xAl_{1-x}(0,2 \le x \le 0,60)$, $V_xAl_{1-x}(0,15 \le x \le 0,50)$ und $Mo_xAl_{1-x}(0,25 \le x \le 0,80)$.

11. Elektronische Vorrichtung nach Anspruch 4, wobei das Metallelement, welches hauptsächlich die Metallverdrahtung bildet, Cu ist, und der amorphe Dünnfilm aus einer Legierung gebildet ist, die ausgewählt ist aus:
$V_xCo_{1-x}(0,15 \le x \le 0,80)$, $Nb_xCr_{1-x}(0,25 \le x \le 0,45)$, $Nb_xCo_{1-x}(0,22 \le x \le 0,55)$, $Ta_xCr_{1-x}(0,25 \le x \le 0,40)$, $Ta_xCo_{1-x}(0,25 \le x \le 0,45)$, $Cr_xCo_{1-x}(0,50 \le x \le 0,70)$, $Mo_xCo_{1-x}(0,20 \le x \le 0,60)$, $V_xCo_{1-x}(0,20 \le x \le 0,60)$, $Ti_xCu_{1-x}(0,18 \le x \le 0,70)$, $Zr_xCu_{1-x}(0,18 \le x \le 0,70)$, $Hf_xCu_{1-x}(0,20 \le x \le 0,70)$, $Y_xCu_{1-x}(0,10 \le x \le 0,53)$ und $Ta_xCu_{1-x}(0,20 \le x \le 0,80)$.

## Revendications

1. Dispositif électronique comprenant:

un film mince amorphe formé sur un substrat, ledit film mince amorphe comportant une structure ordonnée sur une plage courte; et

un câblage métallique présentant une structure cristalline formé directement sur la surface du film mince amorphe,

dans lequel la distance inter-atomique de la structure ordonnée du film mince amorphe correspond approximativement à l'espacement des plans cristallins du câblage métallique qui incluent des atomes séparés par la première distance inter-atomique la plus proche.

2. Dispositif électronique selon la revendication 1, dans lequel une couche isolante ou une couche de barrière est interposée entre le substrat et le film mince amorphe.

3. Dispositif électronique selon la revendication 1, dans lequel des gorges sont prévues sur la surface du film mince amorphe.

4. Dispositif électronique selon la revendication 1, dans lequel le câblage métallique est essentiellement réalisé en un métal choisi parmi le groupe comprenant Al, Cu, Au, Ag et W.

5. Dispositif électronique selon la revendication 1, dans lequel le câblage métallique est essentiellement formé en un métal choisi parmi Al pur structuré fcc, Cu pur, Au pur, Ag pur, un alliage Al-Cu, un alliage Al-Ti, un alliage Al-Cr, un alliage Al-Ta, un alliage Al-Mg, un alliage Al-In, un alliage Al-Li, un alliage Cu-Be, un alliage Cu-Ag, un alliage Au-Pt, un alliage Au-Ag, un alliage Au-Pd, un alliage Au-Cu et W pur structuré bcc.

6. Dispositif électronique selon la revendication 5, dans lequel le câblage métallique est essentiellement formé en l'un des alliages et dans lequel le câblage métallique comprend en outre du Si selon une quantité de 1% en poids ou moins.

7. Dispositif électronique selon la revendication 1, dans lequel l'énergie de surface de la phase cristalline du matériau formant le film mince amorphe est supérieure à l'énergie de surface d'un matériau formant le câblage métallique.

8. Dispositif électronique selon la revendication 1, dans lequel le film mince amorphe contient au moins un élément choisi parmi l'élément métallique formant essentiellement le câblage métallique, un élément permettant de former un composé inter-métallique avec l'élément métallique formant essentiellement le câblage métallique et un élément permettant de former une série continue de solution solide dans l'élément métallique formant essentiellement le câblage métallique.

9. Dispositif électronique selon la revendication 5, dans lequel le film mince amorphe contient au moins deux éléments choisis parmi l'élément métallique formant essentiellement le câblage métallique, des éléments du groupe III A, des éléments du groupe IV A, des éléments du groupe V A, des éléments du groupe VI A, des éléments du groupe VIII, B, C, N, O, P, Si et Ge.

10. Dispositif électronique selon la revendication 4, dans lequel l'élément métallique formant essentiellement le câblage métallique est Al et le film mince amorphe est formé en un alliage choisi parmi $Ta_xAl_{1-x}$ ($0,20 \leq x \leq 0,85$), $Nb_xAl_{1-x}$ ($0,2 \leq x \leq 0,85$), $V_xAl_{1-x}$ ($0,2 \leq x \leq 0,60$), $W_xAl_{1-x}$ ($0,15 \leq x \leq 0,50$) et $Mo_xAl_{1-x}$ ($0,25 \leq x \leq 0,80$).

11. Dispositif électronique selon la revendication 4, dans lequel l'élément métallique formant essentiellement le câblage métallique est Cu et le film mince amorphe est formé en un alliage choisi parmi $V_xCo_{1-x}$ ($0,15 \leq x \leq 0,80$), $Nb_xCr_{1-x}$ ($0,25 \leq x \leq 0,45$), $Nb_xCo_{1-x}$ ($0,22 \leq x \leq 0,55$), $Ta_xCr_{1-x}$ ($0,25 \leq x \leq 0,40$), $Ta_xCo_{1-x}$ ($0,25 \leq x \leq 0,45$), $Cr_xCo_{1-x}$ ($0,50 \leq x \leq 0,70$), $Mo_xCo_{1-x}$ ($0,20 \leq x \leq 0,60$), $W_xCo_{1-x}$ ($0,20 \leq x \leq 0,60$), $Ti_xCu_{1-x}$ ($0,18 \leq x \leq 0,70$), $Zr_xCu_{1-x}$ ($0,18 \leq x \leq 0,70$), $Hf_xCu_{1-x}$ ($0,20 \leq x \leq 0,70$), $Y_xCu_{1-x}$ ($0,10 \leq x \leq 0,53$) et $Ta_xCu_{1-x}$ ($0,20 \leq x \leq 0,80$).

# FIG. 1

# FIG. 2

# FIG. 3

# FIG. 4

# FIG. 5

FIG. 6

FIG. 7

FIG. 8

FIG. 9 (a)

FIG. 9 (b)

FIG. 9 (c)

FIG. 9 (d)

FIG. 9 (e)

FIG. 9 (f)

# FIG. 10

RESISTANCE CHANGE ΔR/R

1.04
1.03
1.02
1.01
1.00
0.99

THE EXAMPLE

1.0 2.0 3.0 4.0 5.0 6.0 7.0 8.0 9.0 10.0

× 10³ hours

# FIG. 11

32
2
3
5
1
31

# FIG. 12

1000μm
0.8μm
24
22
21
23

FIG. 13

FIG. 14

FIG. 15

FIG. 16

FIG. 17

FIG. 18(a)  FIG. 18(b)  FIG. 18(c)

FIG. 18(d)  FIG. 18(e)

FIG. 18(f)  FIG. 18(g)

FIG. 19

# FIG. 20(a)

5
1

# FIG. 20(b)

36
5
1

# FIG. 20(c)

3
5
1

# FIG. 20(d)

37
5
1

# FIG. 20(e)

2
37
5
1

# FIG. 21

3
2
5
1

# FIG. 22

# FIG.23

I μm

I mm